# EUROPEAN PATENT APPLICATION

(11) **EP 2 154 269 A1**
(43) Date of publication of application: **17.02.2010**
(21) Application number: 08752549.9
(22) Date of filing: 09.05.2008
(51) Int. Cl.: C25F 3/12, B23H 3/06, B23H 3/08, C25D 11/32

(54) **METHOD FOR PROCESSING SILICON BASE MATERIAL, ARTICLE PROCESSED BY THE METHOD, AND PROCESSING APPARATUS**

(30) Priority: 09.05.2007 JP 2007125053
(71) Applicant: Quantum 14 KK, Koganei-shi, Tokyo 184-8588 (JP)
(72) Inventor: WARABISAKO, Terunori, Nishitama-gun Tokyo 190-0182 (JP); SHIMADA, Toshikazu, Tokyo 168-0082 (JP); KOSHIDA, Nobuyoshi, Koganei-shi Tokyo 184-0003 (JP); GELLOZ, Bernard, Koganei-shi Tokyo 184-0012 (JP); KANEHORI, Keiichi, Sayama-shi Saitama 350-1335 (JP)
(74) Representative: Hall, Matthew Benjamin
(86) International application number: PCT/JP2008/058666
(87) International publication number: WO 2008/140058

(57) **Abstract**

In a state where a silicon base material (1) is used as an anode, a fine platinum member (2) is used as a cathode, and an electrolyte solution (4) is arranged between the anode and the cathode, anodic oxidation is performed in constant current mode under the conditions where porous formation mode and electrolytic polishing mode coexist. The platinum member (2) is fitted in the silicon base material (1) with silicon elution, and processes such as hole making, cutting, single-side pressing are performed. Since the silicon base material can be processed at a room temperature with small energy, the crystal quality of the processing surface is not deteriorated. Thus, efficient and highly accurate processing can be performed without using a mechanical method, which consumes much material in conventional processes such as cutting of solar cell silicon base material, and without using laser whose energy unit cost is high, and furthermore, without leaving a crystal damage on a processed surface.

## Description

### TECHNICAL FIELD

The present invention relates to a method for processing a silicon base material, an article processed by the method, and a processing apparatus. More particularly, the invention relates to a method for processing a crystal silicon base material useful for manufacturing a precision processed article, a transistor, LSI or a solar cell, an article of crystal silicon base material processed by the method, parts or elements using the article, and a processing apparatus for processing the same.

### BACKGROUND ART

A crystal silicon solar cell is one that is manufactured and employed most widely among the solar cells subjected to the photovoltaic power generation at the present time. The cost of power energy generated by the photovoltaic power generation is still higher in the present circumstances than the existent power generation methods such as heating power, hydraulic power, and atomic power, whereby there are several issues in respect of the cost of manufacturing, improvement in the photovoltaic conversion efficiency and longer service lifetime of the solar cell to widespread the regenerable energy.

A manufacturing process for the crystal silicon solar cell in practical use at present is largely divided into a step of manufacturing a crystalline substrate, a step of manufacturing a solar cell and a module manufacturing step of incorporating the cell into a desired power generation unit.

The step of manufacturing the crystalline substrate includes the sub-steps of chlorinating or chloridizing metal silicon of low purity obtained by carbon reducing silica stone, reducing again silicon of higher purity obtained by purification in a state of chloride or hydrochloric acid compound, shaping the obtained high purity silicon into an ingot with less impurities or crystalline defects by a crystallization method such as a cast method or Czochralski method, and cutting it out in a plate form.

Also, the manufacturing process for the solar cell that is general in the present circumstances is roughly stated as follows. That is, first of all, for a silicon substrate (wafer) cut out in the plate form from the ingot which is usually formed to have a specific resistivity of about 1Ωcm and a conduction type of p-type, a surface crystalline defect layer formed inevitably in the cutting-out process is removed by etching in a mixed acid or alkaline solution. Then, phosphorus is thermally diffused to form a shallow p-n junction on the surface of the silicon substrate, once removing phosphorus glass formed during the thermal diffusion, forming a silicon nitride (SiNₓ) thin film normally in a thickness of about 80nm for the anti-reflection condition, and removing by gas-etching a phosphorus diffusion layer on the side end surface or back surface of the silicon substrate to remove and separate a part of the p-n junction. Thereafter, a metal paste with aluminum (Al) as the main component is printed and coated on the almost entire back surface, and dried, and further a metal paste with silver (Ag) as the main component is pattern printed in an area for the lead wire to be soldered later. On the surface (light-receiving surface), a small-diameter wiring for reducing resistance of a surface conductive layer and a grid-like pattern for soldering the lead wire are printed by Ag paste, and dried, and burned at a temperature of 700°C or above in this state. The product in this state is a partially fabricated product called a solar cell, in which a step of soldering the lead wire for modularization on the front and back surfaces is a link to a modularization step as will be later performed.

In manufacturing a crystal silicon solar battery module, though the manufacturing process for the crystalline substrate and the manufacturing process for the solar cell as described above are indispensable, the substrate cost takes about 1/3 of the cost of manufacturing of the module, and the cell making cost takes 1/3. Accordingly, it is a very important subject to reduce the substrate cost and the cost of the cell making process in order to realize the cost reduction of the crystal silicon solar battery on the basis of the manufacturing method in the present circumstances. And one of the objects regarding such cost reduction is a slice technique for cutting out the silicon ingot in the plate form.

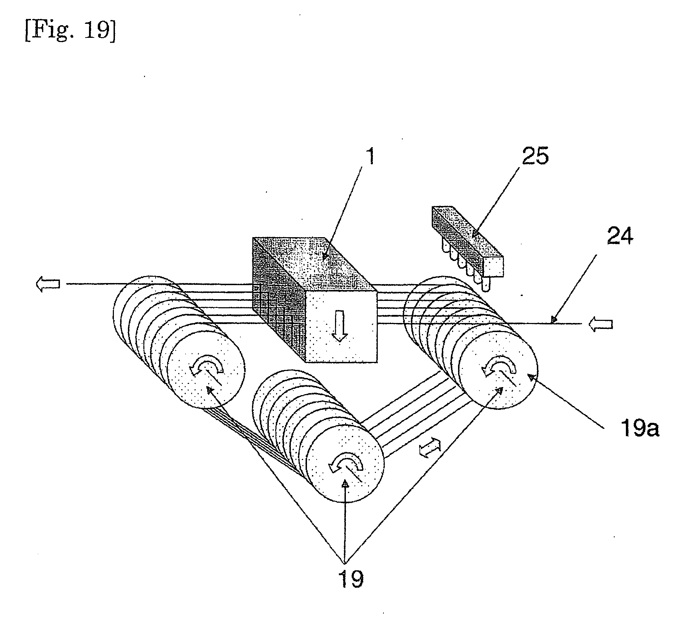

Conventionally, in slicing the silicon ingot, a cutting technique using a multi-wire saw as typically shown in Fig. 19, for example, has been put to practical use (JP-A-05-185419 (patent No. 2571488) and JP-A-09-066522 (patent No. 2891187)). In Fig. 19, reference numeral 19 denotes a main roller for driving a wire 24, with a guide groove worked circumferentially at a slice pitch of the ingot. The wire 24 is wound to circumscribe three main rollers 19 along this guide groove, and dispensed in the reciprocating motion. The wire 24 is typically composed of a piano wire of high tension with a diameter of 150 to 200µm. In slicing the ingot, a slurry in which diamond abrasive grains having a grain diameter of several µm are suspended in a dispersion liquid is supplied from a supply unit 25 to one (main roller 19a in Fig. 19) of the main rollers 19 and coated around the wire 24, and the silicon ingot 1 is pressed against a group of wires running in parallel. The silicon ingot 1 may be a columnar single crystal rod formed by a pulling method, or a prism-like rod cut out of a polycrystalline lump obtained by the cast method. In either case, the silicon ingot 1 which is temporarily bonded on a support board (not shown) is vertically moved slightly to be closer to the group of wires together with the support board according to a cutting speed and cut at the same time to produce a number of thin plate substrates.

The slice method by this multi-wire saw has a relatively fast cutting speed of 200 to 300µm/minute and a high productivity of producing 1000 or more substrates at the same time by winding the wire multiple times, and is standardized as the method for producing the solar cell silicon substrate.

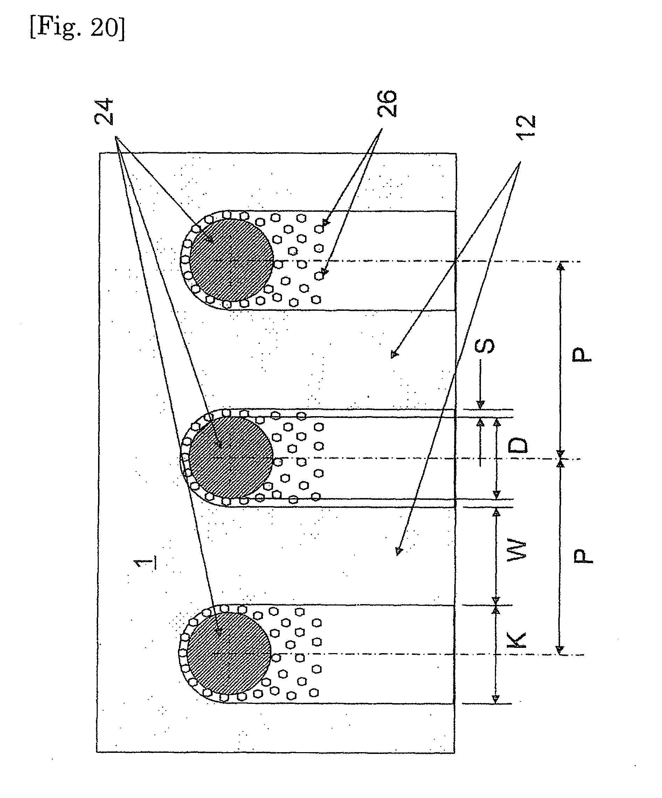

However, with this method, there is an essential problem in making the silicon substrate thinner. Fig. 20 typically shows a cross-sectional situation of how the cutting of the ingot progresses, in which the cutting of the silicon ingot 1 progresses to be scraped by diamond abrasive grains 26 supplied to the plurality of wires 24 sliding in the direction perpendicular to the paper face, consequently forming a thin silicon substrate 12. A thickness W of the obtained silicon substrate 12 is the value of a guide groove pitch P of the main roller 19 as a basic size, excluding a cutting margin K decided by a wire diameter D and a cutting spacing S as large as two or three times the abrasive grain diameter. With this method, though it is possible to produce the thin substrate itself, it is required that the ingot yield (=W/P) is not lower at the same time. In order to reduce the thickness W of the silicon substrate and the cutting margin K at the same time, it is required that the wire diameter D and the abrasive grain diameter are made smaller. On the other hand, if the wire diameter is smaller, the wire 24 is easier to cut and if the abrasive grain diameter is made smaller, the cutting speed is decreased, whereby the productivity is sacrificed in either case, and the situation is almost critical in the present circumstances from the viewpoint of the substrate cost.

Also, because of cutting by the mechanical method such as machining, a damage layer (crystalline defect layer) as thick as one to three times the abrasive grain diameter is left on the substrate surface, whereby it is common practice to remove by etching this damage layer at the beginning of the cell making process. In the thin substrate, this further becomes a factor of decreasing the ingot yield.

Also, with the ingot slice method using the multi-wire saw, because the cutting is performed using the diamond abrasive grains, cutting the wire itself as well as the silicon ingot occurs at the same time. Therefore, the wear and tear of the wire are severe, whereby the wire as long as several hundreds km is usually discarded once it is delivered in the short reciprocating sliding motion. Also, the abrasive grains are preferentially recovered from cutting chips, and the silicon chips are not reused. Therefore, the consumables cost caused by the slice process is an obstacle of the lower cost of the silicon substrate.

As described above, with the conventional ingot slice method, the thickness or the yield of the silicon substrate almost reaches the limit in the solar cell manufacturing process, whereby it is necessary to introduce a revolutionary cutting method that did not exist ever before to produce the thinner substrates at higher yield economically.

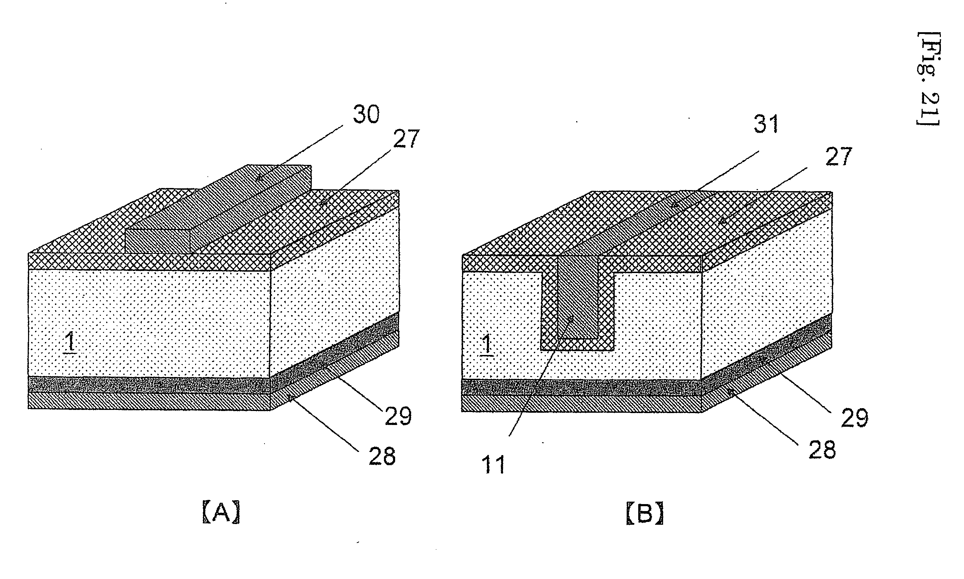

In the cell manufacturing process, there is a demand for the lower cost of processing the substrate to realize the highly efficient cell structures. A typical cell structure is a relatively flat layer structure as shown in Fig. 21A. In Fig. 21A, reference numeral 1 denotes a p-type silicon substrate, for example, in which an n-type layer 27 with phosphorus diffused is formed on the surface (light-receiving surface), a high concentration p-type layer 29 with aluminum of a back electrode 28 diffused is formed on the back surface, and a comb-like surface electrode 30 (partially shown in the figure) is formed on top of the n-type layer 27.

The subjects with such typical structure are light shield and resistance of the surface electrode 30. It is required that the surface electrode 30 is provided at an interval to reduce the sheet resistance of the n-type diffusion layer 27, and typically a slender parallel grid-like electrode at an interval of 2 to 3mm. Usually, the pattern is formed by a screen printing method or the like, in which the thickness of a silver burned layer obtained by one time of printing is about 10µm, and it is formed at a width of 200 to 300µm to obtain a desired resistance value. Also, a common collecting electrode (bus bar) orthogonal to this parallel grid-like electrode has a width of 3 to 4mm to flow a large current. Therefore, the percentage (light shield ratio) at which the electrode covers the light-receiving surface of the solar cell is great, and may exceed 10% in some cases.

To solve such a problem, a buried contact structure as shown in Fig. 21B has been proposed and put to practical use for the high efficiency purpose. This structure is such that a deep groove 11 having a width of 50 to 100µm and a depth of 50 to 100µm is provided on the surface (light-receiving surface) side of the p-type silicon substrate 1, the n-type phosphorus diffusion layer 27 is formed to cover the surface (light-receiving surface) of the cell including the surface of the deep groove 11, and the high concentration p-type layer 29 with aluminum diffused from the back electrode 28 is formed on the back surface of the cell, like the typical cell. The deep groove 11 has such a structure that a buried electrode 31 is formed by embedding silver by a plating method or the like. In this buried contact structure, the projected area onto the light-receiving surface is small because the aspect ratio of the electrode is large, in which the electrode shield ratio can be made 5% or less. Thereby, an output improvement of 5% is attained over the typical cell structure, the line resistance of the electrode is reduced because the cross-sectional area of the electrode is large, and the contact resistance is reduced due to the enlarged contact area with the n-type layer, whereby the series resistance of the cell is decreased, achieving the effect of improving the fill factor of the cell.

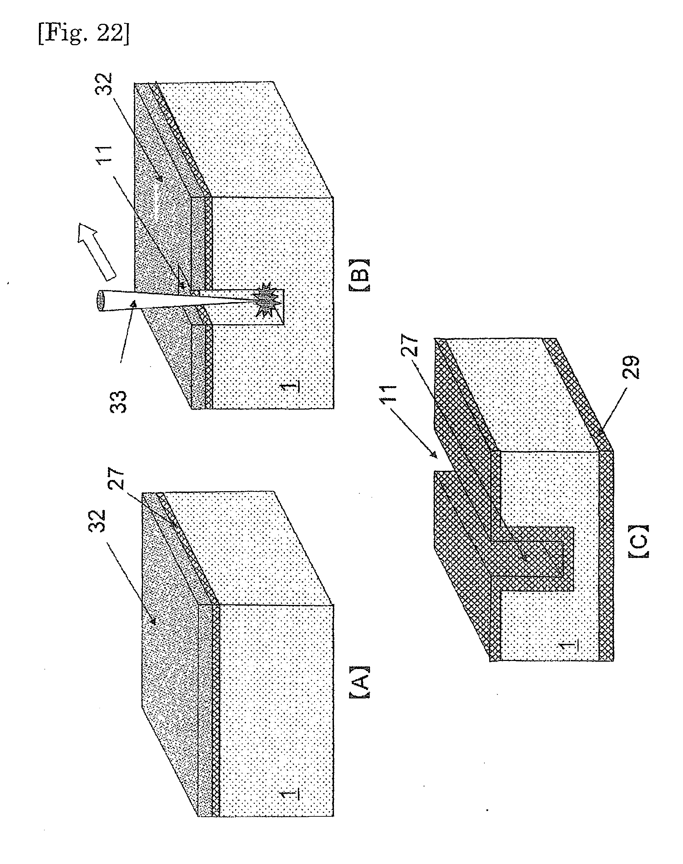

A step of forming this deep groove 11 includes forming a surface oxide film 32 in forming the surface diffusion layer 27 on the silicon substrate 1, as shown in Fig. 22A, and applying a laser beam 33 via the surface oxide film 32, while scanning, to form the deep groove 11 by ablation, as shown in Fig. 22B. Thereafter, phosphorus diffusion is made on the bottom and the side wall of the deep groove 11 to allow the low resistance contact with the buried electrode, as shown in Fig. 22C. This method has a larger number of steps than the other general methods, and because the laser beam whose energy unit cost is high is employed to make drawing, the process cost increases. Therefore, the buried contact cell is limited in the use to the purposes particularly requiring the high efficiency, and has not been yet employed widely.

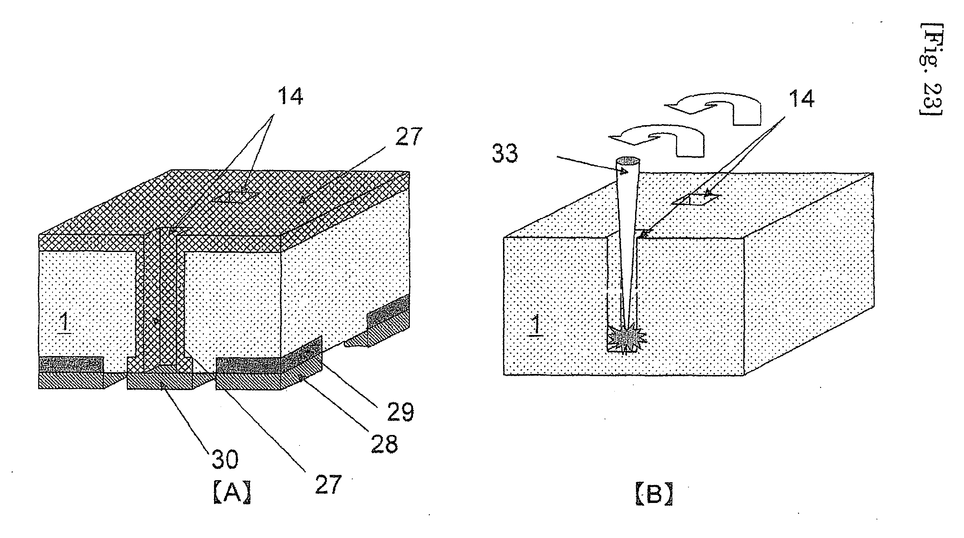

As another method for the high efficiency structure, a through hole emitter structure called an emitter wrap through (emitter-wrap-through) as typically shown in Fig. 23A has been proposed, as disclosed in D. Kray, et al., Proceedings of 3rd World Conference on Photovoltaic Energy Conversion, 2003 (12-16 May 2003) Vol. 2, pp. 1340-1343. In this structure, for example, the p-type silicon substrate 1 is provided with an array of fine holes 14 penetrating through the front and back surfaces, through hole side surface and a part of the back surface being also covered with the same n-type phosphorus diffusion layer 27 as on the surface (light-receiving surface), and the n-type region electrode 30 which is usually provided on the surface side is formed on the back surface. In the p-type region of the bulk, the p-type high concentration area 29 is provided to form the back electrode structure 28. The p-type high concentration area 29 is formed by selective diffusion of boron or diffusion of aluminum from the back electrode 28 like the general structure.

An advantage of this structure is that the incident light of near 100% can be utilized because the electrode shield on the light-receiving surface is smaller than the buried contact cell as previously described, in addition to the aesthetic point that there is no electrode on the surface. Further, there is another advantage on the process that the series connection of cells in modularization is permitted on the same plane of the back surface because the electrodes are concentrated on the back surface. However, in the present circumstances, a processing method for forming the through fine holes 14 on the front and back surfaces of the substrate step by step using the laser beam 33 is employed, as shown in Fig. 23B, in which there is a disadvantage that the cost of manufacturing is high.

### DISCLOSURE OF INVENTION

### PROBLEMS THAT THE INVENTION IS TO SOLVE

The present invention has been achieved in the above-mentioned background, and it is an object of the invention to provide new technical means that can overcome various problems associated with the multi-wire saw normally used in the slice process for the silicon ingot in the manufacture of the crystal silicon solar cell, that is, the limited thinly-sliced thickness of the substrate, the yield of the silicon material, the consumables cost for the slice, and the formation of the crystalline defect layer on the silicon substrate surface after cutting, as well as the limited cost of manufacturing in the mechanical cutting technique with the limited consumed energy required for the process, and further the limited cost of manufacturing taken by processing the substrate using the normal laser in the high efficiency cell manufacturing process with the limited consumed energy required for the process.

### MEANS FOR SOLVING THE PROBLEMS

The present invention has a main feature of applying a processing principle based on the electrochemical reaction to a manufacturing process for the crystal silicon solar cell in order to essentially solve various problems associated with the conventional mechanical or thermal processing techniques such as laser evaporation.

That is, according to the invention, there is provided a method for processing a silicon base material, using as the main components the silicon base material, a counter electrode provided in opposition to and in proximity to the silicon base material, and an electrolyte solution arranged between the silicon base material and the counter electrode and in contact with them, in which the silicon base material is used as an anode and the counter electrode is used as a cathode, and including a step of performing anodic oxidation of the silicon base material by flowing a current between the silicon base material and the counter electrode, in which the silicon base material is selectively removed by changing the relative position between the silicon base material and the counter electrode with the time and fitting the counter electrode into the inside of the silicon base material while dissolving the silicon base material locally. In this description, such processing to progress locally and self-consistently is called "fitting".

In addition, as a feature of the invention that can be put to practical use simply and stably, there is discovered the following new fact. The counter electrode is a metal such as platinum, and a good conductor of electricity. Though the silicon to be processed is semiconductor, its specific resistivity greatly depends on the amount of active impurities mixed and is usually 1,000Ωcm or less, or about 0.01 to 10Ωcm for the microchip or solar cell, unlike an insulating material of usually 1,000,000,000Ωcm or more in the incorrect definition. Therefore, in a situation where metallic good conductor and silicon semiconductor that is not metal but has high conductivity are contacted in the electrolyte solution, it is natural that any contact at one point will cause electrically a short circuit to possibly stop the anodic oxidation operation. Therefore, it should be considered that the usage of the invention is impossible or very unstable and difficult to put it to practical use. However, as a result of experimental researches by the present inventors, it has been found that the above short circuit is not seen practically at all, and even if the short circuit occurs momentarily, the self-reset will occur. As a result, the invention has been achieved.

The most important feature of the invention as described above has not been contrived or anticipated before as the technical idea. And the feature consequently stands on a reasonable processing principle of the electrochemical reaction.

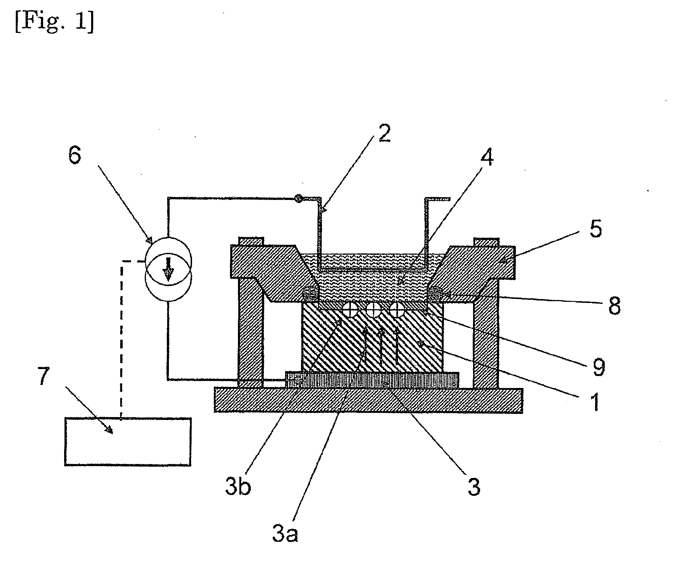

Though the processing technique of the invention allows various usages of processing the silicon base material of the crystal silicon solar cell, the processing principle common to those processing methods will be firstly described below using a simple constitution as shown in Fig. 1.

It is a phenomenon of "anodic oxidation" that is a basis of the invention. The requisites for performing anodic oxidation of the silicon substrate include an electrolytic bath 5 for storing an electrolyte solution 4, a power source 6 and a power controller 7, a cathode (typically platinum) 2 and an anode 3 connected to the power source, an anodic oxidation work-piece (silicon substrate in this case) 1 connected to the anode 3, and the electrolyte solution 4 arranged between the anodic oxidation work-piece 1 and the cathode 2, as shown in Fig. 1, for example. In this example, the silicon substrate 1 is placed on the top of the anode 3, with a seal 8 provided between the electrolytic bath 5 and it to prevent leakage of the electrolyte solution 4. This seal is provided to prevent the electrolyte solution 4 from directly contacting the anode 3, but is not necessarily provided depending on the apparatus constitution. By flowing current via the silicon substrate 1 and the electrolyte solution 4 to the cathode 2, a hole current 3a flows toward the substrate surface, especially when the silicon substrate is p-type, so that the anodic oxidation reaction occurs because a positive hole 3b is supplied to a contact portion with the electrolyte solution 4. When the supply of positive hole is small, a porous anodic oxidation layer 9 may be formed in some cases, as will be described later. However, under the operating conditions of the invention, the silicon atom of this portion elutes in the electrolyte solution, so that this portion is lost.

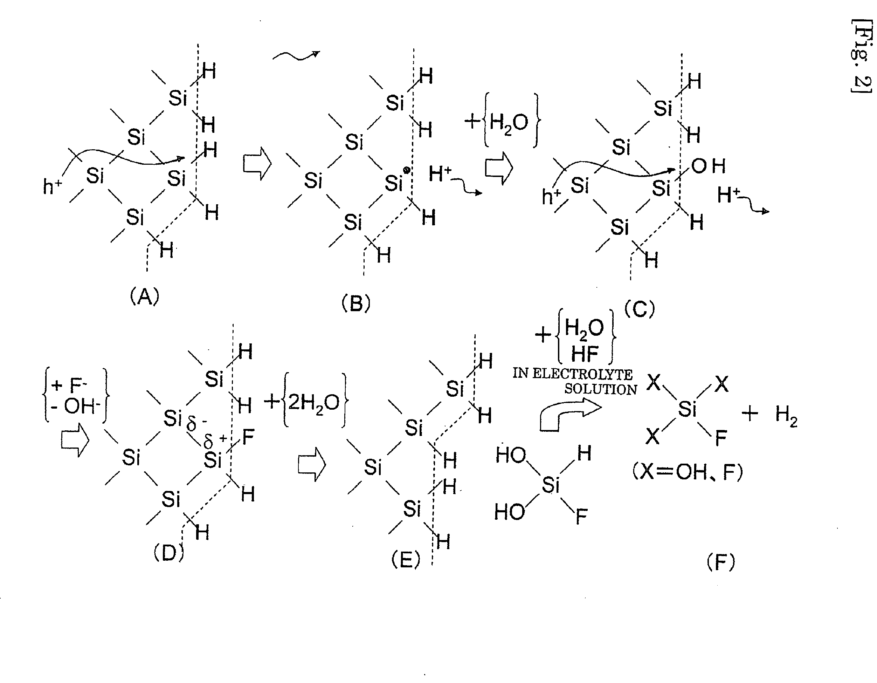

A mechanism for dissolving the p-type silicon substrate is understood by a reaction model as proposed by Allongue et al. (P. Allongue, "Properties of Porous Silicon (L. Canham ed.)", INSPEC, IEE(1997), pp.3-11) and shown in Fig. 2, for example. The surface of the silicon substrate dipped in the hydrofluoric acid solution is terminated by hydrogen atom as represented in an atomic model of Fig. 2A. In this state, the silicon substrate exists stably. If the positive hole (h⁺) is supplied there by flowing current with a small current density at the electrolytic polishing peak or less, one Si atom for two positive holes dissolves in the electrolyte solution through a process from Fig. 2A to Fig. 2E. In Fig. 2A, if hydrogen atom (proton) on the surface is liberated by the supply of positive hole from the bulk, a dangling bond of Si is formed on the substrate surface at the same time, and further reacts with the supplied positive hole and water molecule (H₂O) in the solution to change to hydroxyl group (-OH), while discharging the proton (Fig. 2B to Fig. 2C). A fluoric ion (F⁻) in the electrolyte solution acts on this and is replaced with hydroxyl group (-OH) (Fig. 2D).

At the stage from Fig. 2D to Fig. 2E, the undissociated HF and H₂O molecules act on the back bond of Si on the crystal surface strongly polarized by the SiF bond, giving H atom to Si(δ⁻) atom to pull out Si(δ⁺) atom, so that the generated HFSi(OH)₂ compound is liberated in the electrolyte solution. The HFSi(OH)₂ compound is hydrolyzed by further receiving the action of HF and H₂O in the electrolyte solution to generate an H₂ gas. Through this series of reaction, one hydrogen molecule and two protons are generated on the substrate surface with the dissolution of one Si atom.

If the current density is so high that the supply of positive hole is sufficient, the rate at which Si-H bond is replaced with Si-OH is fast, and a process for generating Si-O-Si, namely, silicon oxide by bridging of adjacent Si-OH is predominant, whereby the operation transfers to a so-called electrolytic polishing mode in which the silicon oxide film is dissolved by hydrofluoric acid.

Since the reaction progresses by the supply of positive hole, the reaction is accelerated if the pair of positive hole and electron is generated by application of light. Also, in the n-type silicon substrate, the anodic oxidation reaction hardly progresses in the dark place because the number of positive holes is small. However, in a situation where the positive hole is supplied by application of light, the anodic oxidation reaction occurs according to a way of flow.

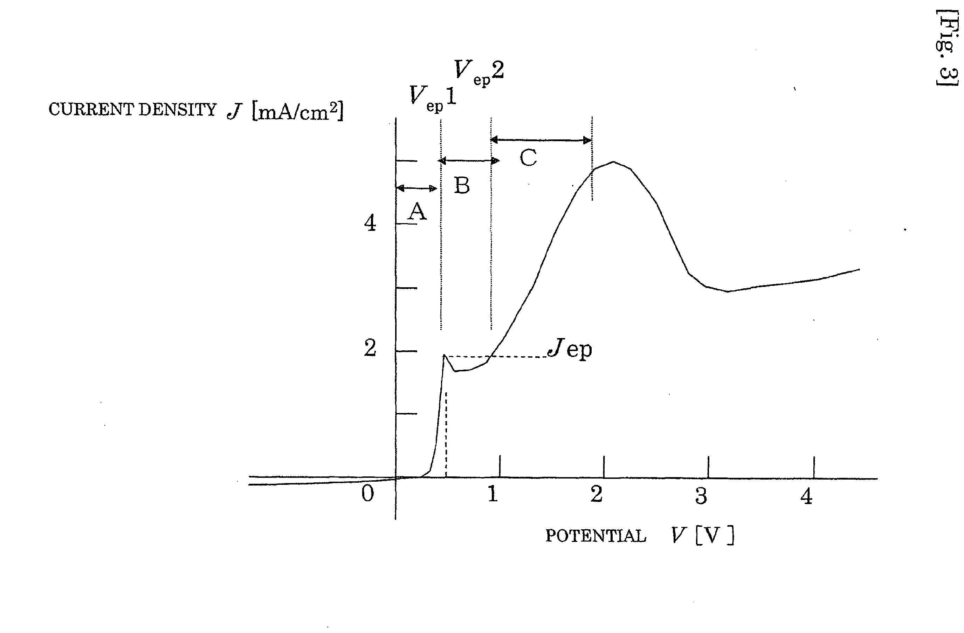

Fig. 3 shows a typical J-V (current density to voltage (potential)) curve in performing anodic oxidation of the p-type silicon base material in the diluted hydrofluoric acid solution. The current-voltage characteristic is not simple, but as the potential increases, the current rapidly increases at first, passing through a sharp peak, once falling, and increasing again. This current peak is called the "electrolytic polishing peak", in which the value Jₑₚ hardly depends on the kind of the substrate, but depends on the composition of the electrolyte solution. Assuming the potential indicating the electrolytic polishing peak to be Vₑₚ1, the fine hole is formed in the crystal silicon in an area A of 0<V<Vₑₚ1, forming a porous structure. For the purpose of obtaining the porous layer, a part of smaller current is employed in this current area A.

An area of Vₑₚ1<V is called the "electrolytic polishing area", in which the fine hole is not formed in the crystal silicon, but the surface state depends on the current density. In order to obtain the smooth electrolytic polishing surface, a part of larger current density is usually employed in the current area greater than Jₑₚ, namely, an area C of Vₑₚ₂<V.

In the processing of the surface according to the invention, it is undesirable that the fine pores are formed near the surface of the cut work-piece, and it is undesirable that the wider area is etched in the electrolytic polishing mode, whereby it is required that an area of smaller current density is used in the electrolytic polishing mode. The area can be defined as an area B, namely, Vₑₚ1<V<Vₑₚ2, which is greater than the "electrolytic polishing peak" Jₑₚ and smaller than the potential Vₑₚ2 at which the current density that has once fallen becomes a greater value than the value of the "electrolytic polishing peak". However, since the voltage is applied in the constant current mode in the invention, the current value becomes almost constant at Jₑₚ, but the voltage value fluctuates slightly beyond the range from Vₑₚ1 to Vₑₚ2. The anodic oxidation mode takes the range from the upper limit of a formation mode of the porous metamorphic layer to the lower limit of a mode of obtaining the smooth electrolytic polishing. This area is the anodic oxidation area which has not been conventionally employed for the purposes of forming the porous layer or making the electrolytic polishing of the plate base material. If the invention is applied to the purpose of making the precise processing of the silicon base material, the use of this area is suitable, in which the condition can be said as the "intermediate area where the porous layer formation mode and the electrolytic polishing mode coexist". Though the specific voltage area is varied depending on the specific resistivity of the silicon base material, the composition of electrolyte solution, the apparatus structure and the anodic oxidation current level, the effect of the invention can be expected in the above area Vₑₚ1<V<Vₑₚ2, in which the typical external applied voltage value is in the range from about 0.3V to 20V. Of course, if the processing speed improvement is required rather than the processing precision, the operation in the area of Vₑₚ2 or greater is effective, and may work on the area C.

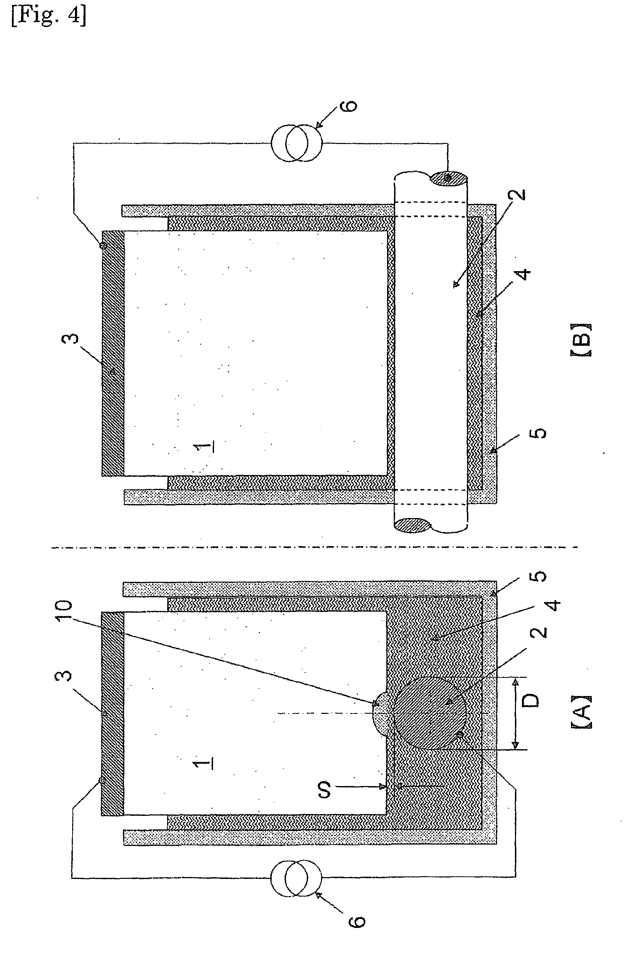

In the above explanation, it is supposed that the uniform anodic oxidation layer is formed on the substrate surface, or the flat etching is performed in the wide range on the substrate surface such as electrolytic polishing. Though the structure of the cathode and the action in the anodic oxidation have not been greatly noted before, Fig. 4 is a cross-sectional view typically showing the application situation of the invention, which is based on the idea that if the cathode 2 is made smaller and the anodic oxidation is performed in proximity to the silicon base material 1 in Fig. 1, the current is concentrated near the cathode, whereby the local anodic oxidation is allowed. Particularly, if the operation is performed in the operable area of the invention, the local processing of the silicon substrate is allowed. Herein, Fig. 4A is a front view in cross section, and Fig. 4B is a side view in cross section. In Fig. 4, reference numeral 1 denotes a p-type silicon substrate, and reference numeral 3 denotes an anode electrode provided in contact with the silicon substrate 1. Reference numeral 2 denotes a filament cathode electrode, usually using a platinum wire having a diameter D of 0.5mm or less. A power source 6 is connected between the anode 3 and the cathode 2. The silicon substrate 1 and the cathode 2 are dipped in the electrolyte solution 4 held in the electrolytic bath 5, so that the current flows from the silicon substrate 1 via the electrolyte solution 4 to the cathode 2. The anode 3 is arranged separately from the electrolyte solution 4 so that current may not directly flow from the cathode 2. In an example of the explanation, the structure where it is not simply dipped is applied but it may be separated using a function of the seal 8 in Fig. 1. When the anodic oxidation is started, the cathode 2 is arranged in proximity to the silicon substrate 1, with the spacing S being smaller than the cathode wire diameter. If the operation is performed in the constant current mode, they may be contacted. The upper limit of the external applied voltage depends on the specific resistivity of the silicon substrate 1, and may be about 10V for the solar cell. In such a case, the current density of the anodic oxidation current in the electrolyte solution 4 is higher in a part where the cathode 2 and the silicon substrate 1 are proximal, and since the supply of the positive hole current from the anode side is concentrated in this part, the elution of silicon on the silicon substrate surface occurs concentrically in an area 10 nearest to the cathode electrode. If the relative position between the cathode 2 and the silicon substrate 1 is not changed, the elution part 10 is only widened, but if the relative position is changed to make the cathode 2 closer to the silicon substrate 1 along with the elution, the elution shape of silicon is different.

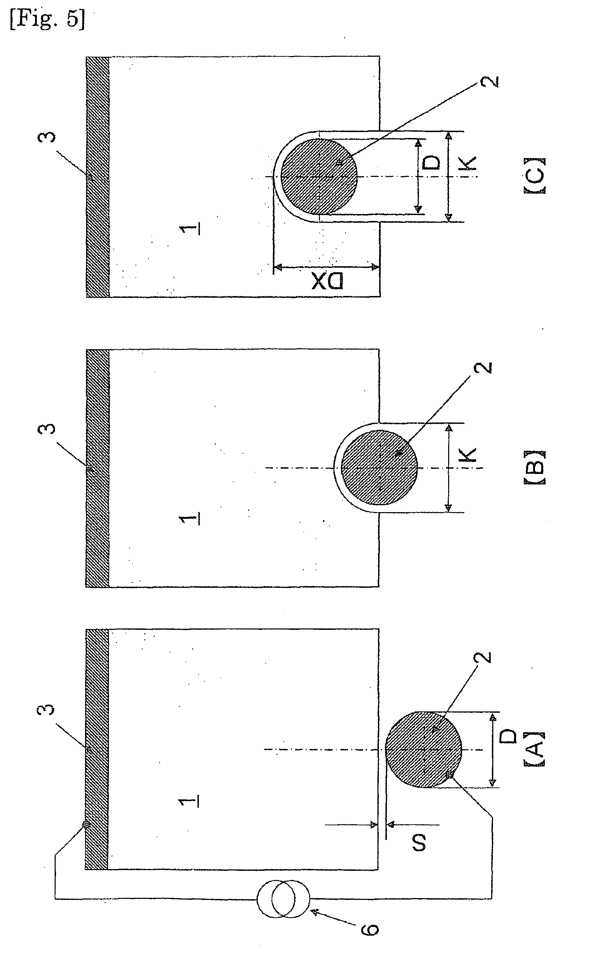

Figs. 5A to 5C show the behavior with the passage of time, in which the constitution is the same as in Fig. 4, although the electrolyte solution is omitted. Fig. 5A shows the start time of anodic oxidation, in which if the cathode 2 is moved to the silicon substrate side in synchronism with the elution of silicon, the silicon surface is retracted along the cathode shape so that the cathode 2 is fitted into the silicon substrate 1 as shown in Fig. 5B. Further, if the anodic oxidation is continued, silicon elutes like the deep groove in a width close to the diameter of the cathode 2, as shown in Fig. 5C. This is the result that because most of the positive holes in charge of the anodic oxidation reaction are supplied from the anode electrode side, the silicon elution around the cathode 2 is predominant on the side of the anode electrode 3, and the cathode 2 is moved to approach the anode electrode 3 along with the elution of silicon. Since the cathode 2 is always moved in the direction to the anode electrode 3, and kept in a state where the distance from the silicon substrate 1 is the narrowest in the advancing direction, the groove width of the formed deep groove is hardly increased on the silicon substrate surface side, so that the deep groove having the width K slightly larger than the diameter D of the cathode filament can be formed.

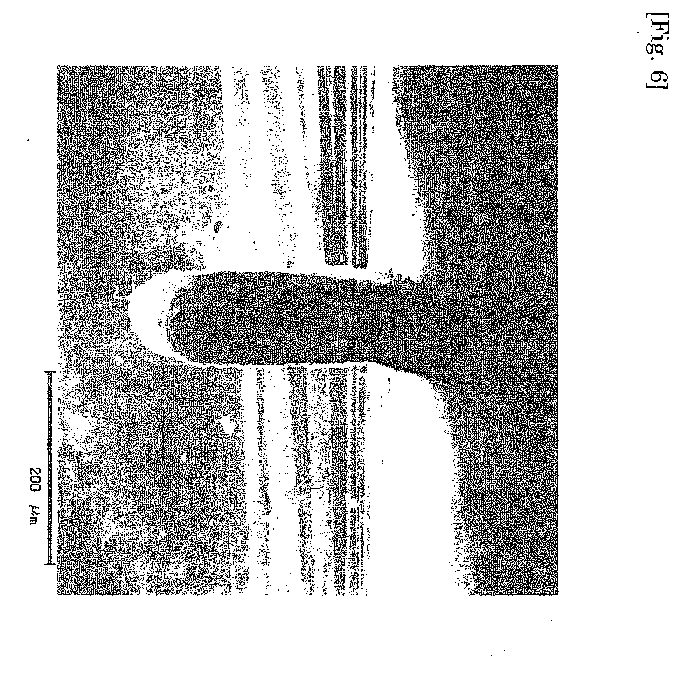

Fig. 6 shows an example of actual processing in the above state. The diameter of the used platinum cathode is 50µm, the silicon substrate is p-type and has a specific resistivity of 2Ωcm, and the electrolyte solution is 49% hydrofluoric acid to ethanol = 1 to 1. The anodic oxidation was performed for 20 minutes in the constant current mode where the current (current density) per unit length of platinum wire was 20mA/cm. At this time, the external applied voltage to the silicon substrate was in the range of 6±1V. Fig. 6 is a view of observing the cross section of the silicon substrate after the anodic oxidation by a scanning electron microscope, in which the groove with the width shorter than 100µm is formed over the depth 200µm or more along the locus of the platinum cathode. Though the groove width is almost double the diameter 50µm of the platinum cathode, it can be found that the groove is processed without change of groove width along with the fitting of the platinum wire. Also, the processed surface has small irregularities but the formation of fine pores is not recognized.

The spread of the groove width from the diameter D of the cathode filament is slightly different depending on the anodic oxidation conditions, and is generally 20µm or less. If the moving direction of the cathode 2 is changed intentionally, the cross-sectional shape of the groove can be changed, following the moving direction.

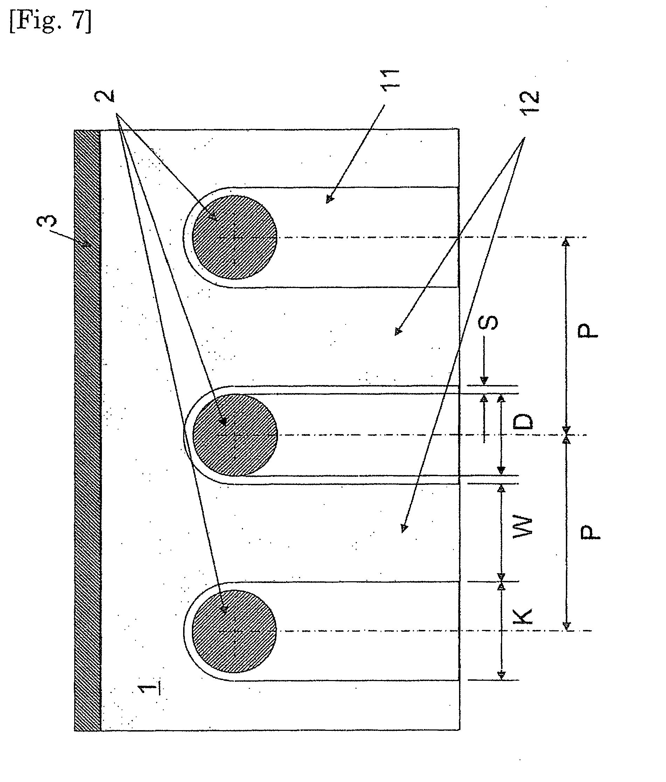

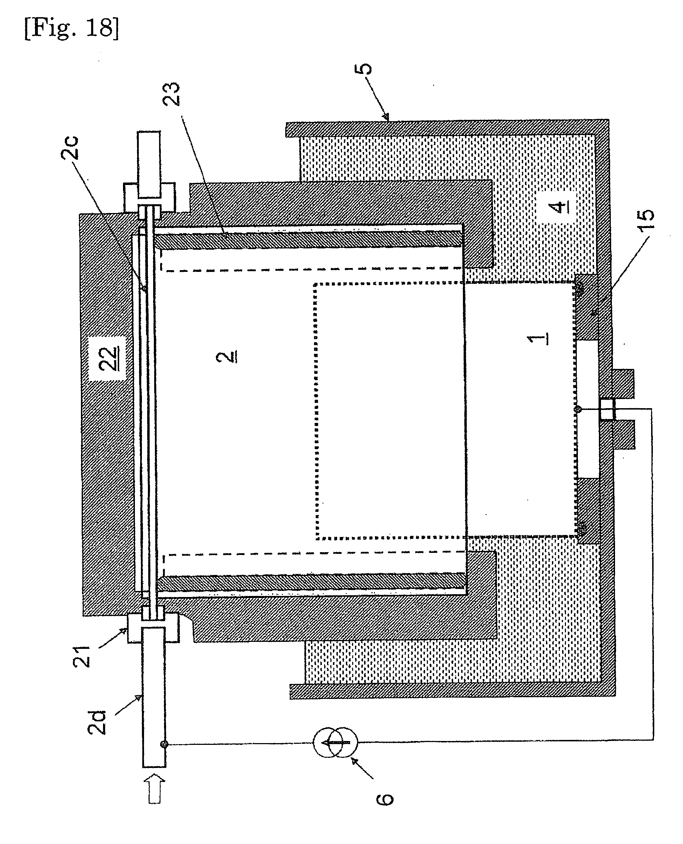

Fig. 7 is a typical cross-sectional view of performing the anodic oxidation with the cathode in which a plurality of filament electrodes having the same diameter are arranged in parallel, like the multi-wire saw as shown in Fig. 18. The anode electrode 3 was provided on the top of the silicon base material 1, and the anodic oxidation was performed while moving the cathode filament group 2 upward from the bottom of the silicon substrate 1. For the sake of simplicity, the electrolyte solution is omitted in the figure, but the situation is the same as shown in Fig. 4. In this case, the cathode filaments 2 are arranged at pitch P, and fitted into the silicon substrate along with the progress of the anodic oxidation, although the width K of the residual groove 11 is about double the spacing S larger than the diameter D of the cathode filament 2, and almost constant. This spacing depends on the anodic oxidation conditions, and is within about 20µm owing to the main factors including the hydrogen bubble generated by the anodic oxidation and the mechanical vibration caused by the driving of the cathode filament 2. As a result, the silicon plates 12 having the thickness W are obtained by the number of filament spaces at the same time. That is, the slice processing for the silicon ingot can be performed by applying the invention.

Though in the above explanation, the anode is the metal electrode formed ohmically on the silicon substrate and the cathode is the platinum filament, the shape of electrode may be appropriately changed. For example, the anode may be the liquid or solid electrolyte in contact with the silicon substrate, or may be a metallic or graphite jig or electrode probe for fixing the silicon substrate if the specific resistivity of the silicon substrate is sufficiently smaller than 1Ωcm. Also, the material of the cathode is a metal unaffected by hydrofluoric acid and having less ionization tendency, and even if it is incorporated into silicon as a slight amount of impurities, there is desirably no electrical influence, whereby platinum is usually used, but to fulfill the above function, other materials such as chromium or carbon may be usable. The shape of the cathode is not limited to filament or plate, but may be any preprocessed shape according to the processing purpose. Also, it is not necessary that the entire electrode is made of the same material, but the electrode may have such a structure that at least an exposed surface at a top end portion to process the silicon substrate is the cathode material, and the current flows via that portion. In the electrode structure in which the cathode material is exposed only at the top end portion for processing, the electrode processing itself is complex, but there is another advantage. This advantage is that the other portion of the electrode is unexposed and in a near electrical isolation state from the processed material in other than the area where the processing progresses, whereby the electric field is concentrated in the exposed portion of the electrode and the processing progress area for the work-piece, so that the current flows concentrically through that portion. In this situation, it is unnecessary to consider the anodic oxidation reaction in other than the processing progress area, whereby the processing can be performed in the electrolytic polishing mode with high current density. In this case, the local processing such as perforating or cutting can be performed at higher processing speed.

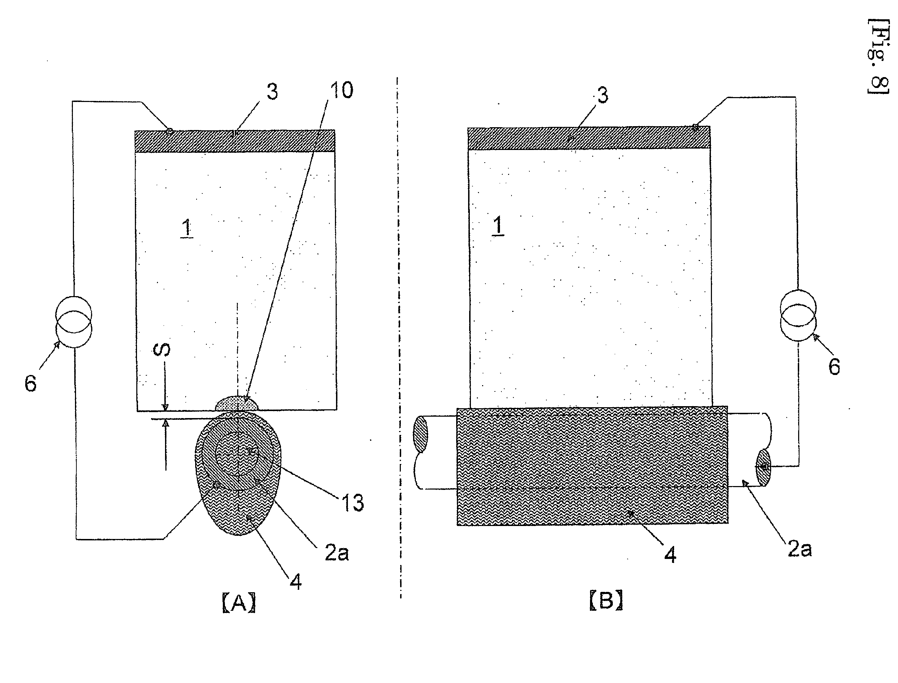

Though in the above explanation, the silicon substrate 1 of the work-piece is dipped in the electrolyte solution 4, if such requisites are satisfied that the electrolyte solution 4 exists between the cathode 2 and the processed part of the work-piece, the reaction product is appropriately removed, and the electrolyte lost by the reaction is successively supplied, the constitution may be arbitrary, in order to achieve the processing purpose with the anodic oxidation. For example, in a state where the electrolyte 4 is exuded and supplied from the inside of a filament cathode 2a that is hollow and exudative so that the surface of the filament electrode 2a is always covered with the new electrolyte solution 4, the filament cathode 2a may be brought into contact with the work-piece, as shown in the typical cross-sectional view of Fig. 8. Fig. 8A is a cross-sectional front view showing the system constitution, and Fig. 8B is a cross-sectional side view. The silicon substrate 1, the anode electrode 3 and the power source 6 are the same as shown in Fig. 4, but the cathode electrode 2a is a hollow filament made of a material in which platinum power is sintered, for example, a unit (not shown) for supplying the electrolyte solution 4 is provided at at least one end to fill the electrolyte solution 4 in an inside 13 of the hollow filament, and the filament surface is wet enough to produce liquid droplets with the electrolyte solution 4. In this case, it is not required that the electrolytic bath is filled with the electrolyte solution 4. With this constitution, the anodic oxidation processing equivalent to dipping in the electrolyte solution is allowed, in which the one part 10 of the silicon substrate 1 in contact with the hollow cathode 2a is selectively subjected to the anodic oxidation, so that the deep groove processing of silicon is performed in a slightly larger width than the outer diameter of the hollow cathode 2a by moving the hollow cathode 2a to the silicon substrate side in synchronism with the elution of silicon. In this case, since the anodic oxidation reaction progresses in a state where the new electrolyte solution 4 is always supplied, the anodic oxidation of silicon is performed more efficiently.

Even if the silicon substrate 1 of the work-piece is dipped in the electrolyte solution 4, it is possible to improve the current efficiency in the processing such as cutting by providing means for suppressing current flowing through the electrolyte solution 4 from the cathode 2 to the silicon base material 1 other than the processed part.

In the anodic oxidation reaction in the operation area of the invention, the silicon near the cathode is dissolved without forming the fine pores in the surface of the silicon substrate, whereby the invention can be applied to the constitution of the electrolytic bath for electrode, the structure of the electrode, the positional relation with the silicon substrate, or various processes in manufacturing the crystal silicon solar cell. The member consumed by the processing is only the electrolyte solution, and there is almost no wear and tear of the other mechanical members.

With the electrochemical processing method of the invention, the processing energy required to remove the silicon atom is almost equal to the reaction energy, and the wasteful thermal energy often generated by the other processing methods is not required, whereby the energy efficiency is extremely high. Since the processing is allowed at room temperature, and only the heat generated during the chemical reaction causes a temperature elevation near the processed surface, without introducing the crystalline defect, whereby there is a very great advantage as the processing method of the semiconductor crystal.

Also, the anodic oxidation reaction supplies a large amount of nascent active hydrogen to the substrate surface along with the reaction, as described in the explanation of the reaction mechanism. The silicon surface terminated by hydrogen is inactive to recombination of positive hole and electron pair, and especially in the polycrystalline silicon in which more grain boundaries remain, there is the effect of improving the efficiency of the solar cell by increasing the lifetime of minority carrier.

Also, since the electrolyte solution for use in the invention contains EL class hydrofluoric acid, pure water or ethanol with less metal impurities useful for the surface washing or removal of the surface oxide film during manufacturing of the silicon semiconductor, it is possible to transfer to the next semiconductor process by only washing with pure water after processing. Therefore, there is the economical effect that a rewashing process which is often performed between steps in the solar cell manufacturing process can be omitted or simplified.

Further, the silicon compound eluted in the electrolyte solution can be recovered and regenerated as the semiconductor silicon again. This is because the cathode material is covered at least on the surface with platinum, electrochemically extremely stable and not eluted in the electrolyte solution during the anodic oxidation reaction, whereby the electrolyte solution is not contaminated with metal impurities. There is also the economical effect of increasing the utilization efficiency of expensive high purity silicon which is an important subject for the crystal silicon solar cell.

### BRIEF DESCRIPTION OF DRAWINGS

Fig. 1 is a view showing the apparatus constitution for explaining a processing principle of the invention.
Fig. 2 is a view showing an atomic model for explaining the reaction for use in the invention.
Fig. 3 is a graph representing the relationship between potential and current for explaining the operation condition for use in the invention.
Fig. 4 is a typical cross-sectional view for explaining the components and the processing situation of the invention.
Fig. 5 is a typical cross-sectional view for explaining the components and the processing situation of the invention.
Fig. 6 is a cross-sectional photomicrograph of a silicon base material as a result of applying the invention.
Fig. 7 is a typical cross-sectional view showing a processing situation of the silicon base material by applying the invention multiple times.
Fig. 8 is a typical cross-sectional view showing another processing situation of the silicon base material by applying the invention.
Fig. 9 is a typical cross-sectional view showing a processing technique of the silicon base material in an embodiment 1.
Fig. 10 is a typical cross-sectional view showing another processing technique of the silicon base material in the embodiment 1.
Fig. 11 is a typical cross-sectional view showing the constitution and the processing situation of a silicon substrate hole making apparatus in the embodiment 1.
Fig. 12 is a typical view showing the constitution of a silicon substrate selective etching apparatus in an embodiment 2.
Fig. 13 is a typical view showing the constitution and the processing situation of a silicon ingot slice apparatus in an embodiment 3.
Fig. 14 is a typical view showing another constitution and the processing situation of the silicon ingot slice apparatus in an embodiment 4.
Fig. 15 is a partial detailed view of the silicon ingot slice apparatus in the embodiment 4, showing the constitution of implementing a method for moving the ingot.
Fig. 16 is a typical view showing the electrode structure for cutting the silicon base material in an embodiment 5.
Fig. 17 is a typical view showing the electrode structure for cutting the silicon base material in the embodiment 5.
Fig. 18 is a typical view showing the constitution and the processing situation of the silicon ingot slice apparatus using the improved electrode in the embodiment 5.
Fig. 19 is a typical view showing the constitution and the processing situation of the silicon ingot slice apparatus in the prior art.
Fig. 20 is a typical cross-sectional view showing the silicon ingot slice processing situation in the prior art.
Fig. 21 is a typical view showing the structure of a solar cell in the prior art and the structure of an improved solar cell.
Fig. 22 is a typical view for explaining a manufacturing process for the improved solar cell in the prior art.
Fig. 23 is a typical view for explaining another manufacturing process for the improved solar cell in the prior art.

### BEST MODE FOR CARRYING OUT THE INVENTION

The present invention is suitably applicable to several manufacturing processes especially for the solar cell, which will be described below by way of example.

### EMBODIMENT 1

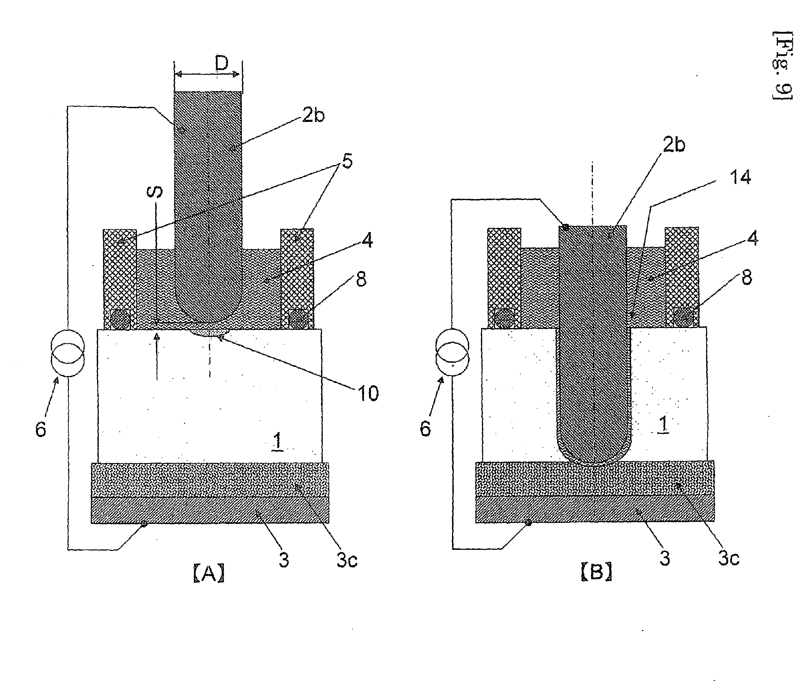

Fig. 9 is a cross-sectional view of an embodiment 1 of the present invention, showing the anodic oxidation progress situations A and B in due order in forming a fine hole in a silicon substrate. The apparatus constitution will be described below in Fig. 9A. Reference numeral 1 denotes a work-piece, which is a p-type silicon substrate, 100mm square, having a specific resistivity of 1Ωcm and a thickness of 200µm. The silicon substrate 1 is fixed to a metallic fixture and anode 3 via a solid organic conductor electrode (trade name example: Nafion film) 3c having a thickness of about 200µm and to an electrolytic bath 5 composed of a support frame made of Teflon (registered trademark). An electrolyte solution 4 in which 49% hydrofluoric acid solution and ethanol are mixed at 1 to 1 is held by the silicon substrate 1 and the electrolytic bath 5. An O-ring seal 8 is provided at a contact portion with the silicon substrate 1 on the lower surface of the support frame made of Teflon (registered trademark) so that the electrolyte solution 4 may not leak. The solid organic conductor electrode 3c is used to avoid direct contact of the electrolyte solution 4 with the metallic anode 3 and secure electric conduction between the silicon substrate 1 and the anode 3. The metallic anode 3 is electrically connected to the anode side of a power source 6. An opposed cathode 2 is a platinum wire having an outer diameter of 100µm and a length of 5mm, held by a platinum plate (not shown) and electrically connected to the cathode side of the power source 6.

In starting the silicon processing, a top end of the cathode 2 is placed in proximity to the silicon substrate 1, a spacing S between the silicon substrate 1 and it being smaller than the diameter of the cathode, and may be lightly in contact with the silicon substrate 1. With the upper limit of the applied voltage of the power source 6 set at 2V, the cathode 2 is made to descend at a rate of 10µm/s, while flowing the current between anode and cathode in a constant current mode of 1µA. A neighborhood 10 of the most proximal point of the silicon substrate 1 to the cathode 2 elutes while producing hydrogen bubbles, so that the cathode 2 is fitted into the silicon substrate 1 while descending, and the cathode 2 comes into contact with the solid organic conductor electrode 3c in about 20 seconds and stops. After removing the solid organic conductor electrode 3c, a through hole 14 having an inner diameter of about 150µm was formed. Meanwhile, though the applied voltage fluctuates in some cases, the anodic oxidation reaction does not stop in the middle due to contact between the cathode 2 and the silicon substrate 1. Because of the operation in the constant current mode, when the cathode 2 comes into contact with the silicon substrate 1 being processed, the voltage only drops, and in a state where the electrolyte solution 4 is arranged between the cathode 2 and the silicon substrate 1 due to some fluctuation, the anodic oxidation reaction is resumed. If the cathode 2 comes into contact with the solid organic conductor electrode 3c, a voltage drop state continues, whereby it is easy to detect the end point. By making the setting of automatically stopping the cathode descent if a short circuit state continues for a certain time or more, the fine through hole can be processed in the silicon substrate 1 safely and securely. Also, the hole can be processed in desired depth by determining the descent distance of the cathode 2 beforehand.

Though in the above embodiment, a processing example of the single hole with the single cathode has been described, it is easy that a plurality of cathodes with the same structure are arranged in parallel to process the fine holes for the number of cathodes at the same time.

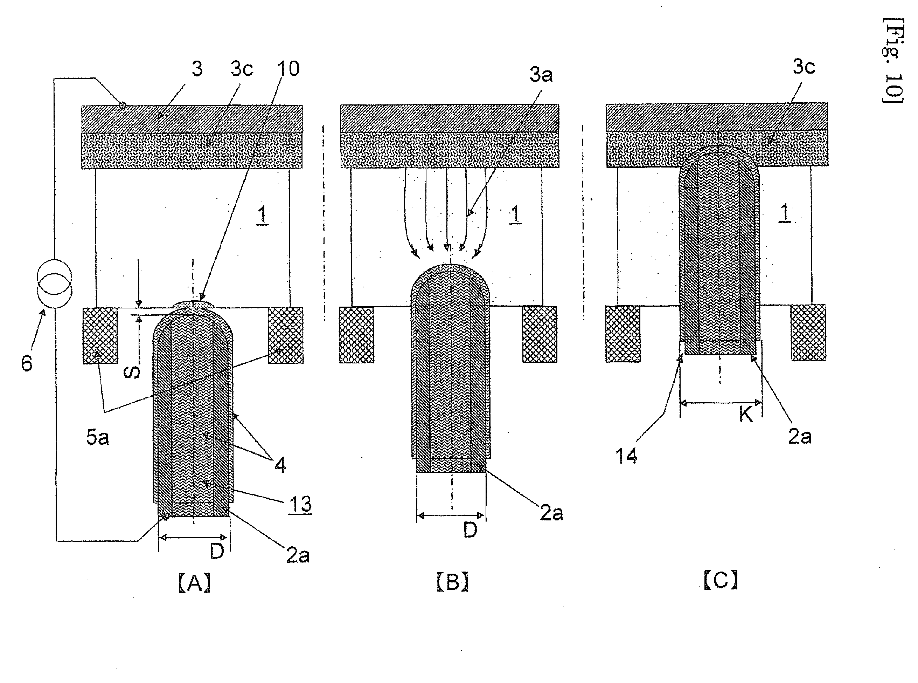

Though in the above embodiment, the processing can be simply made when the aspect ratio for processing is small, the electrolyte solution 4 is not sufficiently supplied as the cathode 2 is fitted, if the aspect ratio of hole is greater, so that the processing speed decreases. In such a case, it is effective to supply the electrolyte solution 4 along the cathode 2. This example is shown in Fig. 10.

In Fig. 10A, the silicon substrate 1 of the work-piece is laid on a Teflon (registered trademark) pedestal frame 5a, and securely held from the top via the solid organic conductor electrode 3c by the metallic anode 3. The metallic anode 3 is electrically connected to the anode side of the power source 6. On the other hand, an opposed cathode 2a is a circular platinum pipe having an outer diameter of 100µm, an inner diameter of 60µm and a length of 10mm, and connected to another circular pipe having a greater diameter, not shown, on the bottom, whereby the electrolyte solution 4 is supplied at a rate of about 1000 pico-liter/second through an inside 13 of the circular pipe. The electrolyte solution 4 effuses from the top end of the cathode to fill between the top end of the cathode 2a and the silicon substrate 1, so that the silicon substrate portion 10 near the cathode 2a is eluted owing to the anodic oxidation reaction.

In Fig. 10B, the behavior of how the top end of the cathode 2a is fitted into the silicon substrate 1 is shown. An anodic oxidation current is supplied from the anode side by a hole current 3a, but since silicon in a part closest to the cathode is eluted at the initial time of fitting, silicon is eluted along the shape of the top end of the cathode, resulting in a state where the top end of the cathode 2a is fitted into the silicon substrate 1.

The line speed of supplying the electrolyte solution in the cathode tube is about 0.6mm/s, and the line speed of the electrolyte solution 4 flowing down the outside of the cathode is about one-half of that value. The new electrolyte solution 4 is always supplied to an anodic oxidation reaction portion, and the reaction product is carried away by the electrolyte solution 4, whereby the initial anodic oxidation reaction rate is kept. A formation speed of the silicon fine hole is about 10µm/s, and the cathode 2a is moved up at this speed.

Since the anodic oxidation current is supplied by the hole current 3a from the anode side, the current is concentrated at the top end of the cathode 2a, whereby the anodic oxidation reaction hardly progresses in the side portion of the cathode 2a. As a result, at the time when the cathode 2a arrives at the solid electrolyte 3c in contact with the anode 3, the fine through hole 14 is formed along the shape of the cathode having an inner diameter K slightly larger than the outer diameter of the cathode 2a, as shown in Fig. 10C.

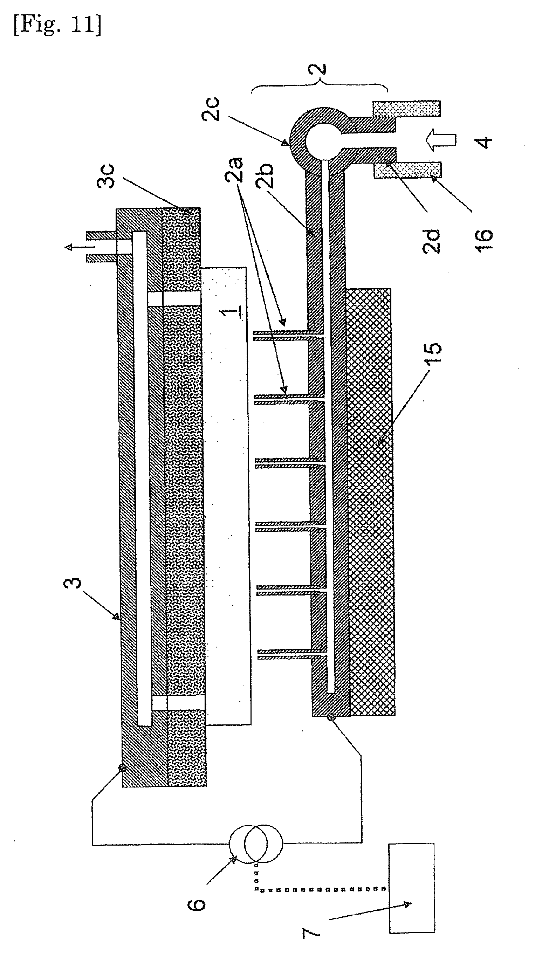

In the structure of the crystal silicon solar cell, there is a method of Emitter-Wrap-Through as described in Fig. 23. In this representative structure, there is a process of forming 100×100 fine holes with a grid of 1mm in the silicon substrate about 100mm square. An example of manufacture to which the invention is applied is shown in Fig. 11. Reference numeral 1 in Fig. 11 denotes the silicon substrate 100mm square to be perforated. Reference numeral 3 denotes the anode of a metallic substrate of about 150mm square, on the surface of which the elastic organic solid electrolyte 3c is mounted. The organic solid electrolyte 3c has an adsorption hole perforated in its periphery with a perimeter length slightly smaller than the silicon substrate 1, the adsorption hole corresponding to an exhaust hole provided in the metallic substrate anode 3, whereby the silicon substrate 1 is fixed to the organic solid electrolyte 3c owing to vacuum adsorption. The metallic substrate anode 3 is electrically connected to the anode side of the power source 6, and the cathode 2 electrically connected to the cathode side of the power source 6 is oppositely provided. The cathode 2 has a bundle of 100 main conduits 2b made of platinum and having an outer diameter of 1mm and an inner diameter of 0.6mm connected to a main piping 2c made of platinum and having and outer diameter of 3mm and an inner diameter of 2mm, in which the main piping 2c is connected via a branch pipe 2d to a liquid sending pipe 16 for supplying the electrolyte solution 4. The main conduit 2b has 100 slender conduits 2a having an outer diameter of 100µm and an inner diameter of 50µm, which are planted at an interval of 1mm, so that the electrolyte solution 4 supplied from the liquid sending pipe 16 exudes from the top end of the 10000 slender conduits 2a. The cathode 2 composed of a group of conduits is fixed on a movable pedestal 15 made of Teflon (registered trademark), and the movable pedestal 15 can be moved up and down in parallel to the anode 3 to precisely change the distance between the silicon substrate 1 fixed to the anode 3 and the cathode 2. The anodic oxidation is performed in the constant current mode while the power source 6 is adjusted in a control system 7, thereby making 10000 through holes having a diameter of 120µm collectively in the silicon substrate 1.

The amount of the electrolyte solution 4 required to form the through holes having a diameter of 120µm in the silicon substrate 1 having a thickness of 200µm is about 12 nanoliter, and the amount of the electrolyte solution 4 consumed to form the 10000 holes in one silicon substrate 1 is about 0.1cc. Though the current required to form the 10000 holes in the silicon substrate 1 at the same time is about 10mA, the current per silicon substrate is about 50mW because the applied voltage is low, whereby there is almost no problem with the temperature elevation. Also, since the processing is ended in about 10 seconds, the net power required for processing is about 0.03 kilowatt-hour/1000 substrates, whereby the processing energy is extremely small.

### EMBODIMENT 2

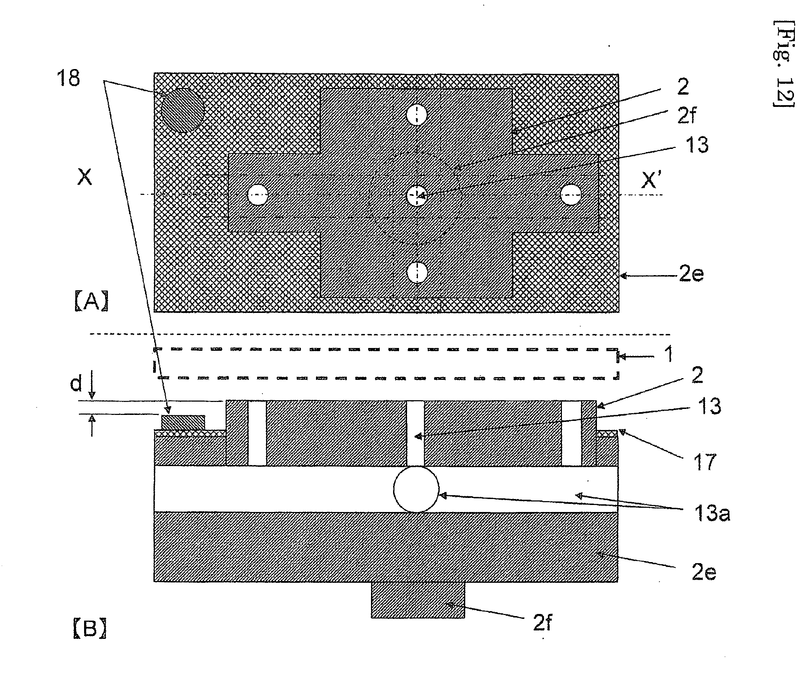

In processing the silicon substrate in the constitution which the electrolyte solution is supplied to the top end of the cathode as described using Fig. 10, the silicon substrate can be etched faithfully to the shape of the cathode as described previously. Using this property, if the cathode is arbitrarily shaped beforehand in projection, the silicon substrate surface can be dug in any shape. Fig. 12 is one example thereof, wherein Fig. 12A is a plan view of the cathode and Fig. 12B is an elevation view taken along the section X-X' in Fig. 12A.

In Fig. 12, reference numeral 2 denotes a protruding portion worked in the plane projection shape of cross with a height of about 5mm, which is installed on a base board 2e. The material of the base board 2e may be metal other than platinum, but its surface is desirably covered with an insulating membrane 17. Also, the protruding portion 2 may have any shape, and is used in the shape corresponding to the grid-like electrode of the buried contact structure as described in connection with Fig. 21B, for example, for the application of the solar cell. In this case, a cross-shaped slender portion corresponds to a finger portion of the solar cell electrode wiring, and a cross-shaped thick portion corresponds to a bus bar portion of the solar cell electrode wiring. The representative dimensions are such that the width of the finger portion is 100µm and the width of the bus bar portion is 300µm. The protruding portion 2 is made of platinum, or at least a portion in contact with the electrolyte solution on the outermost surface needs to be covered with a platinum membrane. A hollow piping 13a is buried in the base board 2e, corresponding to the shape of the protruding portion 2, and the protruding portion 2 is appropriately provided with an electrolyte solution discharge hole 13 having a diameter of 50µm or less. The electrolyte solution discharge hole 13 is connected to the hollow piping 13a, in which the electrolyte solution (not shown) supplied via the hollow piping 13a from the outside is discharged via this hollow piping 13a from the electrolyte solution discharge hole 13. A cathode prop 2f is mounted on the cathode base board 2e, whereby the current can be supplied via the cathode prop 2f to the protruding portion 2. On the surface of the cathode base board 2e other than the protruding portion 2, a stopper 18 is appropriately provided so that a height difference d between the surface of the protruding portion 2 and the surface of the stopper 18 may correspond to the depth of groove dug into the silicon substrate 1. A step difference d is set to 30 to 60µm for the buried electrode.

The silicon substrate 1 is adsorbed to the anode from the top, with the processing surface down, and pressed against the protruding portion 2. While the electrolyte solution of hydrofluoric acid to water to ethanol = 1 to 1 to 1 was supplied from the electrolyte solution discharge hole 13 at about 0.02 to 0.1 milliliter/minute per cm² of protruding portion surface area, a current was flowed from the side of the silicon substrate 1 to the protruding portion 2 in the constant current mode for a few minutes so that the current density on the surface of the protruding portion 2 might be 5 to 10mA/cm². The protruding portion 2 was fitted into the silicon substrate 1, and when the fitting was stopped by the stopper 18, the anodic oxidation process was ended. Thereby, the buried electrode pattern with a depth of 50µm was dug into the silicon surface. This method can be utilized for the ornamental purposes such as impression on the substrate surface, because it is easy to process the repetition of any pattern.

### EMBODIMENT 3

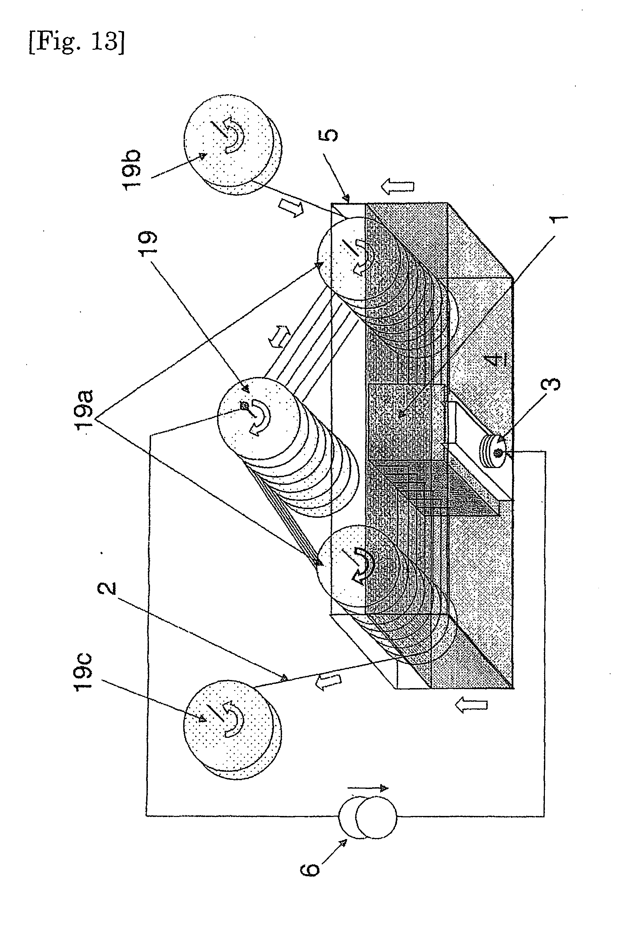

As already described in connection with Fig. 7, the slice processing for the silicon ingot can be performed by applying the invention. The state of implementation will be described below using Fig. 13. Reference numeral 19 in Fig. 13 denotes a main drive roller, in which two reference numerals 19a are wire guide rollers, and reference numerals 19b and 19c are wire delivery and recovery bobbins, respectively. A wire 2 made of platinum is dispensed from the wire delivery bobbin 19b, wounded around the guide rollers 19a and the main roller 19 multiple times, and then recovered into the recovery bobbin 19c. A silicon ingot 1 is mounted on the waterproof anode 3 provided on the bottom of the electrolytic bath 5, and the electrolyte solution 4 is filled in the electrolytic bath 5 to the extent of immersing the silicon ingot. The main roller 19 is electrically connected to the cathode side of the power source 6, and the anode side of the power source 6 is electrically connected via the waterproof anode 3 on the bottom of the electrolytic bath 5 to the bottom of the silicon ingot 1 not to touch the electrolyte solution 4.

The platinum wire 2 is stretched at intervals of slice pitch around one pair of guide rollers 19a, and electrically connected via the main roller 19 to the cathode side of the power source 6, thereby forming a group of cathodes to be opposed to the silicon ingot 1. The platinum wire 2 is gradually dispensed and transferred from the delivery bobbin 19b to the recovery bobbin 19c, while being reciprocated at a larger amplitude than the cut length of the silicon ingot 1 by the main roller 19. After the end of all transfer, the dispensing direction is reversed, whereby the recovery bobbin 19c acts as the delivery bobbin, and the delivery bobbin 19b acts as the recovery bobbin. Since the platinum wire 2 is hardly exhausted, this operation is repeated.

The slice is started when the group of cathodes is immersed in the electrolyte solution 4 by moving up the electrolytic bath 5 and roughly contacts the silicon ingot 1. The electrolytic bath 5 continues to move upward at an elution speed of silicon owing to anodic oxidation in the constant current mode, and the anodic oxidation is ended immediately before cutting the silicon ingot 1 is completed. As already described, the group of cathodes 2 is fitted into the silicon ingot 1, while forming a groove slightly wider than the diameter of the platinum wire 2, whereby the silicon substrates having the thickness of subtracting the groove width from the slice pitch are obtained by the number of platinum wires 2 wound around the main roller 19 at the same time.

In the simple apparatus constitution, the silicon substrate is picked out in a state where it is still linked on the bottom of the silicon ingot, and excised into the individual silicon substrates by the same anodic oxidation apparatus in another substrate recovery apparatus. In the advanced apparatus constitution, a separator sheet made of Teflon (registered trademark) thinner than the groove width to be formed is inserted into the cutting groove along with the progress of the slice, the ingot is lightly pinched from the longitudinal direction by a jig just before the end of slice, and the driving direction of the electrolytic bath is changed to the axial direction of the guide rollers in this state, so that the silicon substrates can be severed together from the silicon ingot base still in the anodic oxidation mode. More simply, the driving of the electrolytic bath is stopped at the last stage, whereby the silicon around the platinum wire is further eluted to make the substrate slender to easily separate a group of sliced substrates from the ingot uncut portion.

The reason of adopting the driving method similar to that of the conventional multi-wire saw is to supply the new electrolyte solution to the cutting portion of the silicon ingot with the cathode, and at the same time to utilize the agitation effect for removing the hydrogen gas of the reaction product and heat. Also, the reason why the cutting is performed from the upper part of the ingot and the ingot is arranged so that the opening portion of groove is formed upward is that the hydrogen bubble of the reaction product is easily removed to realize the smooth supply of the electrolyte solution to the cutting portion, and the movement of the movable portion is reduced by driving upward the electrolytic bath 5 together with the silicon ingot 1 while holding the electrolyte solution 4, thereby suppressing the surface roughness of the cutting groove due to vibration of the cathode filament 2 and minimizing the groove width.

To make the electrolytic bath 5 movable, it is desirable that the electrolytic bath 5 has the minimum size as required, for which it is effective that the guide rollers 19a are smaller in diameter than the main roller 19, and it is effective that the spacing between the guide rollers is set to be slightly wider than the cutting length of the ingot to be sliced. Also, as a result incidental thereto, it is desirable to annex a water supply and drain mechanism for supplying the electrolyte solution to the electrolytic bath and draining the electrolyte solution containing the reaction product dissolved. Another purpose for cutting the silicon ingot in a state where it is dipped in the electrolyte solution is to suppress the vibration of the cathode filament or silicon substrate due to hydrogen generated by the anodic oxidation reaction, and at the same time to effectively remove the joule heat generated by the current.

Though in this embodiment, the cathode filament is a single wire, a stranded wire may be employed to make the agitation effect of the electrolyte solution effective. Also, to positively utilize the agitation effect of the electrolyte solution due to generated hydrogen bubble, it is effective that the group of wires on the cutting plane is not horizontal as in this embodiment, but made at a proper angle to the horizontal to induce the flow of generated hydrogen bubble, its agitation and formation of directional flux and rectify the flow of the electrolyte solution in order to make the shape control of the cutting plane such as smoothing and prevent the lower cutting speed. Also, the more precise shape control of the cutting plane may be made by introducing a surfactant to control the hydrogen bubble size.

In the constitution of Fig. 13, a part of the platinum wire 2 and the silicon ingot 1 are dipped in the electrolyte solution 4 at the same time, and if the silicon ingot 1 is left bare, a reactive current not contributing to the cutting reaction flows from the entire silicon ingot to the platinum wire 2. Therefore, the surface of the silicon ingot 1 is covered beforehand with a thin membrane of fluorine resin or polyimide resin to suppress this reactive current. Since the membrane is thin, the cut membrane is peeled off together along with the progress of the cutting reaction. Also, the already cut portion is exposed to the liquid surface of the electrolyte solution 4 by driving the electrolytic bath 5. The insulating membrane useful for this purpose is the organic resin, but may be a sputter film of silicon carbide or a CVD film such as silicon nitride film to achieve the same effect.

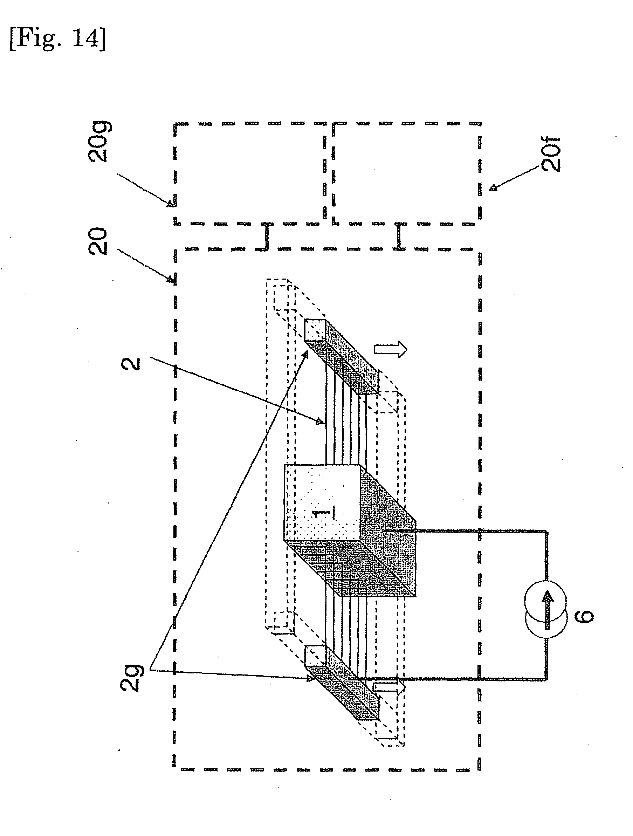

Though in this embodiment, the apparatus constitution using the conventional processing principle of the wire saw is illustrated, the cutting drive mechanism can be further simplified from the gist of the invention. The concept is shown in a typical view of Fig. 14. Reference numeral 1 denotes the silicon ingot of the work-piece, and reference sign 2g denotes a frame-like cathode wire holder for stretching the plurality of platinum wires 2 in parallel at a constant interval and fixing them. Though the electrolytic bath 5 containing the electrolyte solution 4 for immersing the ingot is required as in Fig. 13, it is omitted here for the sake of simplicity of explanation. The wire diameter of the platinum wire 2 is 50µm, for example, in which 1000 wires are fixed at a pitch of 200µm to the frame-like cathode wire holders 2g having an effective length of 200mm. The frame-like holder 2g can be freely transfered in the vertical direction in parallel, but is regulated in motion in the horizontal direction with a backlash of ±5µm or less. The frame-like holder 2g is electrically connected to the cathode side of the power source 6, and the bottom of the silicon ingot 1 is electrically connected to the anode side of the power source 6 not to touch the electrolyte solution (4 in Fig. 13). The frame-like holder 2g is placed on the top of the silicon ingot 1, and fitted into the silicon ingot 1 by its dead weight along with the progress of the anodic oxidation, whereby the cutting progresses quasi-statically. In the deep groove formed in the ingot, the new electrolyte solution 4 is supplied owing to rising hydrogen bubble generated by the reaction, but because the groove width is narrow, the agitation effect is so great as to maintain the anodic oxidation conditions autonomously. Though the potential required for the reaction is 1V or less, and the power required for cutting can be suppressed by controlling the current level, more time for cutting is required, and the current is consumed in the direction to form the fine pores in the silicon in approaching the lower limit of area A in Fig. 3, whereby the current condition close to Jₑₚ is required for the cutting purpose.

In such a simple constitution, the reactive current flowing between the silicon ingot and the platinum wire can be suppressed using mechanical means without processing the membrane covering the silicon ingot. One example is shown in the following.

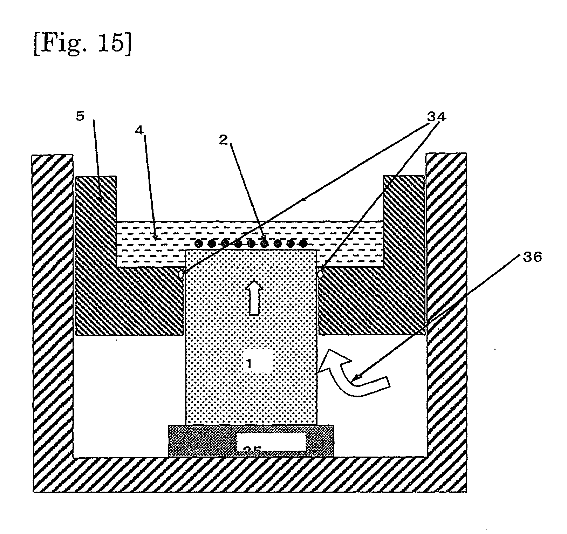

Fig. 15 shows an apparatus having a mechanism 35 for moving the silicon base material 1 from bottom to top through seals 34 in which the electrolyte solution 4 is partly filled in the electrolytic bath 5 with the platinum wire 2 fixed, and the position of the platinum wire is, for example, 10mm deep from the surface of the electrolyte solution. With this mechanism, a part in contact with the electrolyte solution 4 is limited even in processing the silicon base material 1 of large size, whereby the power efficiency can be improved owing to the effects of the invention. This apparatus comprises an electrolyte solution circulation mechanism, not shown in Fig. 15, for keeping the electrolyte solution surface position constant and refilling hydrogen fluoride consumed by the reaction.

The shape of the silicon base material has generally a size discrepancy of 1mm or less, and since there occurs possibly a minute gap between the silicon base material 1 and the seal 34 in the apparatus of Fig. 15, it is effective that a gas 36 such as nitrogen gas is pressed into the gap to prevent a part of the silicon base material 1 to be sealed from contacting the electrolyte solution 4 by the gas layer. Also, the safety and maintenance for the generated combustible gas can be thereby improved.

Also, the silicon base material 1 and the holding mechanism 35 may be fixed in the positional relationship among the silicon base material, the electrolyte solution and the platinum wire equivalent to that of Fig. 15, to move the electrolytic bath 5.

### EMBODIMENT 4

An advantage of the invention is that the surface temperature of the obtained substrate does not rise above a room temperature because the slice processing is performed due to the silicon atoms electrochemically dissolving on the surface of the processing object, the crystalline defect does not occur on the substrate surface because there is almost no mechanical contact with the cathode, and there is no metal pollution other than platinum. Therefore, the cleaning of the substrate after cutting which is required in the case of the wire saw method or etching of the damage layer on the surface of the cut silicon substrate can be omitted. Also, with the wire saw method, though there are wear and tear of the wire or rollers contacted by the abrasive grains, and a regeneration unit for recovering the expensive diamond abrasive grains is required, the electrolyte solution containing hydrofluoric acid and ethanol becoming the reaction solution is consumed in the invention, in which its amount is almost equal to that as consumed in the substrate cleaning required by the conventional method.

Also, hydrogen generated in the anodic oxidation reaction by the slice method of the invention can be recovered, and utilized as the energy source. Though with the conventional method the silicon chips produced by cutting are not generally reused, it is easy in the invention to recycle the recovered compound, because the eluted silicon is high purity HₓSiF_{y} compound and the electrolyte solution itself uses the high purity hydrofluoric acid and high purity ethanol that originally contain less metal impurities. Reference numeral 20 as indicated by the dotted line in Fig. 14 denotes a reaction system vessel for recovering the reaction product, which is provided to cover at least an anodic oxidation treatment portion. The electrolyte solution is supplied from a liquid control system 20f to the anodic oxidation treatment portion, and the electrolyte solution waste liquid after the anodic oxidation treatment is recovered by the liquid control system 20f. Also, in the anodic oxidation treatment portion, hydrogen is generated at the density of the lower limit of explosion or more, and therefore the reaction system vessel 20 is provided to shield the air from the environment, for which the gas control system 20f having the function of replacing the air in the anodic oxidation treatment portion with the inert gas such as nitrogen or capturing the generated hydrogen is annexed.

As described above, the ingot slice technique applying the invention is a method for energy saving and material saving as compared with the conventional method.

### EMBODIMENT 5

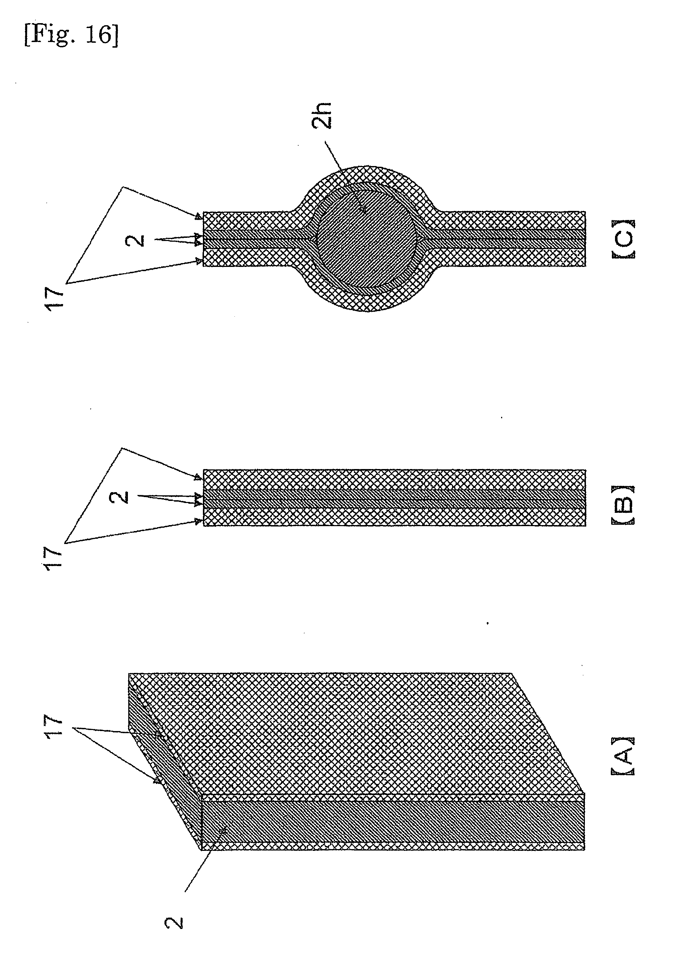

Fig. 16 is an example of the cathode for applying the invention to forming the deep groove in the large base material or cutting the base material. In the explanation of the previous embodiments, the platinum filament or the like for the cathode is exposed. An example as illustrated with a photograph in Fig. 6 is the result obtained by the exposed platinum wire having a diameter of 50µm, and if the cathode diameter is sufficiently smaller than the depth of groove, the groove is formed like a locus passed by the cathode, but as the cutting length is longer, the electrical resistance of the slender platinum wire is higher, whereby it is difficult to supply the anodic oxidation current sufficiently. Instead of the filament, the cathode may be shaped like a strip in cross section, thereby decreasing the resistance of the cathode, but in the case of cutting with less kerf loss or forming the deep groove like slices of the ingot, the wide electrode side face and the work-piece are opposed with a narrow gap for a long time in the shape of strip, bringing about a danger that the etching on the side face progresses, or the deep ultra-fine pores, which are formed when the anodic oxidation current is small, is formed on the surface of the opposed work-piece. Fig. 16A is a suitable example of the cathode for use in this case. Reference numeral 2 denotes a thin plate of platinum having a thickness of 25µm, which has a structure that both the surfaces are coated with an insulating membrane (Teflon (registered trademark) resin) 17 having a thickness of 2µm. The electrical resistance per cm in width (vertical length on the paper face) is about 4mΩ/cm, and the electrode resistance of a cathode blade having an effective blade length of 200mm is 40mΩ at maximum, whereby even if an anodic oxidation current of 10mA/cm is flowed, the voltage drop at the electrode is 5mV or less, and the anodic oxidation mode does not change. To sum up, if the cathode 2 is settled not to be exposed on the back of the blade (upper end on the paper face), the cathode can be used by dipping it in the electrolyte solution.

Fig. 16B is an example of the cathode in the case where an extremely small kerf loss is required, which has a structure that two platinum foils 2 having a thickness of 2.5µm are sandwiched between two Teflon (registered trademark) sheets 17 having a thickness of 15µm. This can be fabricated by pasting the platinum foils 2 having a thickness of 2.5µm on the Teflon (registered trademark) sheets and putting together them. Though the adhesive face of the platinum foil 2 does not necessarily require the electrical contact, the electrical contact from the outside to the platinum foil is important. Since the resistance of the platinum foil 2 is about 22mΩ/cm, it is required to increase the electrode width to decrease the electrode resistance. This sheet-like blade composed of the platinum foils 2 and the Teflon (registered trademark) sheets is usually secured by pulling the periphery outward to make the electrical connection, freely opening one end or one part thereof to perform the cutting in that end or part.

Fig. 16C is an example in which a platinum filament or thin plate structural material is sandwiched between the platinum foils 2 with the structure of Fig. 16B and put together. In this figure, a platinum auxiliary line 2h having a diameter of 500µm is used and sandwiched between the two Teflon (registered trademark) sheets 17 having pasted the platinum foils 2 having a thickness of 2.5µm. In this case, since the platinum auxiliary line 2h takes charge of the structural strength and the lower electrical resistance, the thin Teflon (registered trademark) sheet can be employed, in which a Teflon (registered trademark) coat having a thickness of 2µm may be used according to the purpose. In this case, the thickness of a portion usable as the blade of the cathode can be 10µm or less, and the effective height of the blade (length of a portion under the platinum wire 52 on the paper face) can be up to about 100mm. Accordingly, the base material of about 100mm can be cut with a kerf loss as extremely small as 30µm or less.

In any constitution, since the side face is insulated, it is possible to suppress unnecessary progress of the anodic oxidation reaction on the side wall of the cut groove. On the contrary, there is a problem that the blade passes badly in cutting because there is less change in the groove width. Since the degree of current concentration changes with protrusion of the cathode electrode from the insulating membrane at the blade edge, the invention covers from the state where the cathode is buried in the insulating membrane to the state where the cathode is exposed out of the insulating membrane, although the state can not be indiscriminately specified by cutting as required.

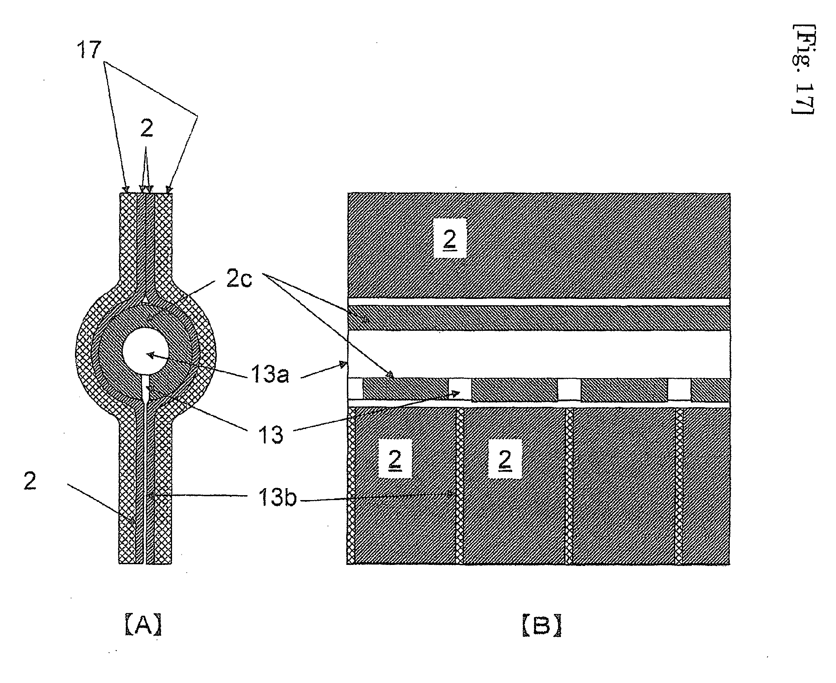

Further, an example of the sheet electrode at improved cutting speed is shown in Fig. 17. Fig. 17A is an elevation view in cross section and Fig. 17B is a side view in cross section. The structure is the same as shown in Fig. 16C, except that the platinum in charge of the structural strength and the lower electrical resistance is not the filament but the platinum pipe 2c having the fine through hole 13 on the side face, and a slender groove 13b is provided in a part of the platinum foil 2 leading to the blade edge. The electrolyte solution (not shown) is transported via the hollow portion 13a of the platinum pipe 2c, and supplied through the fine through hole on the side face and further via the slender groove 13b provided in the platinum foil to the blade edge. The platinum pipe 2c has an outer diameter of 2mm and an inner diameter of 1mm, and the fine through hole 13 on the side wall is perforated into an inner diameter of 100µm by laser beam machining. Also, the groove 13b provided in the platinum foil 2 is provided with a hole having an effective cross-sectional area of 50µm² up to the blade edge by pasting the platinum foil 2 having a thickness of 2.5µm onto the Teflon (registered trademark) sheet having a thickness of 15µm, removing the width of 10µm by laser beam machining, and putting two sheets together. The effective length up to the blade edge is 150mm.

In the sheet-like blade 2 with the platinum foil sandwiched, a part of the platinum pipe 2c is fixed to a sheet blade fixing frame 22 of U-character shape by a clamping ring 21, and the sheet-like blade 2 is fixed to the frame 22 without sag by a tension presser 23, as shown in Fig. 18. The platinum pipe 2c is further connected to the liquid sending pipe 2d, leading to a supply system (not shown) of the electrolyte solution, whereby the electrolyte solution 4 flows from the liquid sending pipe 2d via the platinum pipe 2c along the fine groove 13b provided in the sheet-like blade 2 to leak from the top end of the sheet-like blade 2. On the other hand, the silicon ingot 1 of the work-piece is placed on the seal pedestal 15 provided on the bottom of the electrolytic bath 5 owing to vacuum adsorption, with the bottom of the silicon ingot 1 being electrically connected to the anode side of the power source 6 without touching the electrolyte solution 4 filled in the electrolytic bath 5. The platinum pipe 2c is connected to the cathode side of the power source 6, whereby current returns from the top end of the sheet-like blade 2 proximal to the silicon substrate 1 through the platinum foil via the platinum pipe 2c to the cathode of the power source 6. Along with the progress of the anodic oxidation, the silicon ingot 1 is moved upward together with the electrolytic bath 5 in synchronism with the elusion of silicon, so that the cathode 2 composed of the platinum foil is fitted into the silicon ingot 1. The new electrolyte solution is always supplied from the top end of the sheet-like blade 2 to the area where the anodic oxidation reaction progresses, and the reaction product is discharged from the reaction area effectively, whereby the reaction progresses efficiently and the cutting is performed without decreasing the cutting speed.

In the explanation with Figs. 15 to 18, for the blade for cutting the silicon base material, the insulation on the side face is as illustrated in the figure, and also the portion other than the cutting portion is naturally covered with the insulating material, even at the end in the direction along the blade, so that current is concentrated on the cutting portion. For example, if the blade is filament, the conductive portion of the filament and the filament holding mechanism, except for the portion proximal to the processing part of the silicon base material, is covered with the insulating membrane, suppressing current flowing through the electrolyte solution to other than the processing part. Similarly, if the blade is sheet-like, the insulating membrane covering the side face extends over the end portion of the blade for the platinum sheet, whereby means for suppressing reactive current flowing to other than the processing part is naturally taken.

With the mechanism as described above, the silicon ingot of 100mm square could be cut with a kerf loss of 50µm.

### INDUSTRIAL APPLICABILITY

Though the usefulness of the present invention has been described above in the manufacture of the solar cell that is the severest in respect of the cost, the application of the invention is not limited to the manufacture of the solar cell, but it is clear that the invention may be also useful for the precision processed article using the silicon substrate, the electronic parts such as transistor or LSI, and processing the substrate for manufacturing the elements.

Also, though the invention has been described above using the silicon base material as the work-piece material, it is needless to say that the same base material processing can be made if the anodic oxidation reaction occurs with the similar mechanism for the semiconductor material other than the silicon.

## Claims

1. A method for processing a silicon base material, using as the main components the silicon base material, a counter electrode provided in opposition to and in proximity to said silicon base material, and an electrolyte solution arranged between said silicon base material and said counter electrode and in contact with them, in which said silicon base material is used as an anode and said counter electrode is used as a cathode; and said method including a step of performing anodic oxidation of said silicon base material by flowing a current between said silicon base material and said counter electrode, in which said silicon base material is selectively removed by changing the relative position between said silicon base material and said counter electrode with the time and fitting said counter electrode into the inside of said silicon base material while dissolving said silicon base material locally.

2. The method for processing the silicon base material according to claim 1, **characterized in that** said counter electrode has at least a part of the surface in contact with the electrolyte solution made of or covered with a material having high electric conductivity with platinum, chromium or carbon as the main component.

3. The method for processing the silicon base material according to claim 1 or 2, **characterized in that** said counter electrode is configured such that the area of said counter electrode part in contact with said electrolyte solution is smaller than the surface area of said material having high electric conductivity composing said counter electrode.

4. The method for processing the silicon base material according to any one of claims 1 to 3, **characterized in that** said silicon base material and said counter electrode are kept in the distance smaller than at least the width of an operation part of said counter electrode, or in contact with each other, to process said silicon material.

5. The method for processing the silicon base material according to any one of claims 1 to 4, **characterized in that** said anodic oxidation process includes setting an operation point of the applied voltage in a voltage area that is higher than a voltage at an electrolytic polishing peak current value in the voltage-current relationship between said silicon base material and said counter electrode, and that gives a lower current than the electrolytic polishing peak current value, and locally dissolving said silicon base material under an operating condition where porous silicon formation mode and electrolytic polishing mode coexist.

6. The method for processing the silicon base material according to any one of claims 1 to 5, **characterized in that** said electrolyte solution contains at least hydrogen fluoride and water as the main reaction components.

7. The method for processing the silicon base material according to any one of claims 1 to 6, **characterized in that** in processing said silicon base material, a part of said silicon base material or said counter electrode in contact with said electrolyte solution is electrically shielded to restrict a current flowing through other than a processing part.

8. The method for processing the silicon base material according to claim 7, **characterized in that** in processing said silicon base material, the part of said silicon base material or said counter electrode in contact with said electrolyte solution is electrically shielded by covering said part with a material having corrosion resistance to said electrolyte solution, or closely contacting said material.

9. The method for processing the silicon base material according to claim 8, **characterized in that** any one of fluorine resin, polyimide resin, or their complex, silicon carbide, and silicon nitride is used as the material having corrosion resistance to said electrolyte solution.

10. The method for processing the silicon base material according to claim 6, **characterized in that** at least one part of said silicon base material other than the processing part, or at least one part of said counter electrode proximal to the processing part is covered with an inert gas layer to electrically shield one part of said silicon base material or said counter electrode in contact with said electrolyte solution.

11. A silicon base material processed article **characterized in that** it is processed by the processing method according to any one of claims 1 to 10.

12. The silicon base material processed article according to claim 11, **characterized in that** it is used in manufacturing the electronic parts or semiconductor devices such as precision processed article, transistor, LSI and solar cell.

13. An apparatus for processing a silicon base material, **characterized by** comprising:
a mechanism for holding the silicon base material, a counter electrode provided in opposition to and in proximity to said silicon base material, and an electrolyte solution arranged between said silicon base material and said counter electrode and in contact with them;
a power supply unit having a circuit system for passing current between said silicon base material and said counter electrode, in which said silicon base material is used as an anode and said counter electrode is used as a cathode; and
a mechanism for fitting said counter electrode into the inside of said silicon base material while following the local dissolution of said silicon base material, and changing the relative position between said silicon base material and said counter electrode with the time.

14. The apparatus for processing the silicon base material according to claim 13, **characterized in that** said counter electrode has at least a part of the surface in contact with the electrolyte solution made of or covered with a material having high electric conductivity with platinum, chromium or carbon as the main component.

15. The apparatus for processing the silicon base material according to claim 13 or 14, **characterized in that** said counter electrode is configured such that the area of a counter electrode part in contact with said electrolyte solution is smaller than the surface area of said material having high electric conductivity composing said counter electrode.

16. The apparatus for processing the silicon base material according to any one of claims 13 to 15, **characterized in that** said silicon base material and said counter electrode are kept in the distance smaller than at least the width of an operation part of said counter electrode, or in contact with each other, to process said silicon material.

17. The apparatus for processing the silicon base material according to any one of claims 13 to 16, **characterized in that** said power supply unit sets an operation point of the applied voltage in a voltage area that is higher than a voltage at an electrolytic polishing peak current value in the voltage-current relationship between said silicon base material and said counter electrode, and that gives a lower current than the electrolytic polishing peak current value, and locally dissolving said silicon base material by anodic oxidation under the operating conditions where porous silicon formation mode and electrolytic polishing mode coexist.

18. The apparatus for processing the silicon base material according to any one of claims 13 to 17, **characterized in that** said electrolyte solution contains at least hydrogen fluoride and water as the main reaction components.

19. The apparatus for processing the silicon base material according to any one of claims 13 to 18, **characterized by** comprising means for electrically shielding a part of said silicon base material or said counter electrode in contact with said electrolyte solution to restrict a current flowing through other than a processing part in processing said silicon base material.

20. The apparatus for processing the silicon base material according to claim 19, **characterized in that** said means for restricting the current electrically shields the part of said silicon base material or said counter electrode in contact with said electrolyte solution by covering said part with a material having corrosion resistance to said electrolyte solution or closely contacting said material.

21. The method for processing the silicon base material according to claim 20, **characterized in that** the material having corrosion resistance to said electrolyte solution is any one of fluorine resin, polyimide resin, or their complex, silicon carbide, and silicon nitride.

22. The apparatus for processing the silicon base material according to any one of claims 13 to 21, **characterized in that** said a cathode electrode is provided with a mechanism for supplying said electrolyte solution to an anodic oxidation reaction area.

23. The apparatus for processing the silicon base material according to any one of claims 13 to 22, **characterized by** comprising a mechanism for discharging a gas containing hydrogen generated in the anodic oxidation reaction area as the main component.

24. The apparatus for processing the silicon base material according to any one of claims 13 to 23, **characterized by** comprising a mechanism for discharging a heat generated in the anodic oxidation reaction area.

25. The apparatus for processing the silicon base material according to any one of claims 13 to 24, **characterized by** comprising one or both of a gas control system having a mechanism for capturing and recovering hydrogen generated in the anodic oxidation reaction area, in which a region including at least the anodic oxidation reaction area is covered with a vessel, and a liquid control system having a mechanism for continuously supplying and discharging the electrolyte solution to the anodic oxidation reaction area.
